# EUROPEAN PATENT APPLICATION

(11) **EP 4 839 048 A1**
(43) Date of publication of application: **11.11.2026**
(21) Application number: 25218219.1
(22) Date of filing: 25.11.2025
(51) Int. Cl.: H10D 84/01, H10D 84/83, H10D 89/10, H10D 30/00

(54) **TECHNIQUES FOR FORMING A GATE-ALL-AROUND TRANSISTOR IN A NANOCOMB-TRANSISTOR REGION**

(30) Priority: 06.05.2025 US 202519199645
(71) Applicant: INTEL Corporation, Santa Clara, CA 95054 (US)
(72) Inventor: KUMAR, Ranjith, Austin, TX 78717-4200 (US); SCHENKER, Richard E., Portland, OR 97229 (US); SUNG, Seung Hoon, Portland, OR 97229 (US); JAYANTI, Srikant, San Leandro, CA 94579 (US); KAVALIEROS, Jack T., Portland, OR 97229 (US)
(74) Representative: Viering, Jentschura & Partner mbB Patent- und Rechtsanwälte

(57) **Abstract**

Techniques for forming a gate-all-around transistor in a nanocomb-transistor region can enable a hybrid transistor architecture with flexibility in performance options. According to one example, both merged-nanoribbon gate-all-around transistors and nanocomb transistors may be formed by controlling the distance between fins (e.g., the distance between nanoribbon stacks). For example, patterning a stack of alternate layers of a first semiconductor material and a second semiconductor material into fins may involve forming parallel and adjacent fins that are closely-spaced and forming other parallel adjacent fins that are more widely spaced. A dielectric wall/spine material is then deposited over and between the fins, where portions of the dielectric material between the closely-spaced fins merge to form a dielectric wall. The dielectric material can then be removed between the widely-spaced fins.

## Description

### Background

For the past several decades, the scaling of features in integrated circuit (IC) structures has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize every portion of an IC structure becomes increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a perspective view of an example nanoribbon-based field-effect transistor (FET), according to some embodiments of the present disclosure.
FIGS. 2A-2B are top-down plan views of examples of IC structures IC fabricated using techniques for forming a gate-all-around transistor in a nanocomb-transistor region, in accordance with embodiments of the disclosure.
FIGS. 3A-3E illustrate different cross-sectional views of an example of an IC structures fabricated using techniques for forming a gate-all-around transistor in a nanocomb-transistor region, in accordance with embodiments of the disclosure.
FIG. 4 is a flow diagram of an example method for fabricating an IC structure using techniques for forming a gate-all-around transistor in a nanocomb-transistor region, in accordance with some embodiments.
FIGS. 5A-5C, 6A-6C, 7A-7C, 8A-8C, 9A-9C, and 10A-10C provide cross-sectional side views at various stages in the fabrication of an example IC structure according to the method of FIG. 4, in accordance with some embodiments.
FIG. 11 illustrates a cross-sectional view of an example of an IC structure fabricated using techniques for forming a gate-all-around transistor in a nanocomb-transistor region, in accordance with some embodiments.
FIG. 12 is a top view of a wafer and dies that may include any of the IC structures disclosed herein, in accordance with any of the embodiments disclosed herein.
FIG. 13 is a side, cross-sectional view of an IC device that may include any of the IC structures disclosed herein, in accordance with any of the embodiments disclosed herein.
FIG. **14** is a side, cross-sectional view of an IC package that may include any of the IC structures disclosed herein, in accordance with various embodiments.
FIG. 15 is a side, cross-sectional view of an IC device assembly that may include any of the IC structures disclosed herein, in accordance with any of the embodiments disclosed herein.
FIG. 16 is a block diagram of an example electrical device that may include any of the IC structures disclosed herein, in accordance with any of the embodiments disclosed herein.

### Detailed Description

Disclosed herein integrated circuit (IC) structures fabricated using techniques for forming a gate-all-around transistor in a nanocomb-transistor region. The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Integrated circuits may be designed using a library of cells. For example, a cell in such a library may define a pre-designed component or logic gate, such as an inverter, a flip-flop, or other component. Cells in a library may be designed to fit within defined physical and electrical standards so that the cells may be laid out in the desired locations to build the desired circuit. For example, cells may be "standard height" or "single height" cells with a pre-defined cell size (e.g., height and width), where the height may refer to a dimension of the cell along the y-axis in a top-down view, and the width may refer to a dimension of the cell along an x-axis in a top-down view. Other cells may be "double height," where a double height cell has a larger height than the standard cell (e.g., twice the height).

As the cell dimensions are scaled down, the dimensions of the transistors in those cells are also shrinking. For example, as cell height shrinks, the nanoribbon width of nanoribbon-based transistors in a cell also shrink. In some cases, smaller nanoribbon widths can negatively impact device performance, such as in high-current driver circuits. Another challenge encountered when scaling down the standard cell height is the worsening ratio of active regions to "dead space" or gaps without active regions (e.g., spacing or gaps that may be required by design rules). Using double-height cells may address performance issues for high-current circuits. For example, an extra wide nanoribbon in a double height cell may be formed, which utilizes the dead space between two nanoribbons in a standard height cell.

Another way to improve the ratio of active regions to dead space while also increasing transistor performance is to employ a "nanocomb" transistor architecture, which may also be referred to as a spineFET or forksheet transistor architecture. A nanocomb transistor architecture may enable a reduction in cell dimensions and parasitic capacitance, where the name "nanocomb/forksheet/spineFET" arises because of its bilateral finned structure. In an example nanocomb transistor arrangement, the nanoribbons are coupled with a dielectric "spine" or wall, and there is no gate enclosure on one of the two sides of the vertical stack of lateral nanoribbons or nanosheets (referred to in the following as "nanoribbons"), while the gate enclosure on the other side still remains. Thus, a nanocomb transistor architecture may be considered a "three-sided" transistor architecture (e.g., gate around three sides), in contrast to a "gate all around" transistor architecture which may be considered a "four-sided" transistor architecture (e.g., gate around four sides).

Thus, a nanocomb transistor architecture may enable a reduction in dead space between nanoribbons, which may translate to increased nanoribbon width and improved drive and performance. However, the formation of nanocomb transistors and gate-all-around (GAA) transistors (such as the double-height merged nanoribbon transistors mentioned above) utilize different process techniques. For example, nanocomb transistors involve the formation of a dielectric spine between two adjacent nanoribbons, whereas a dielectric spine is absent in a GAA transistor. Therefore, existing semiconductor manufacturing techniques may preclude the formation of a gate-all-around transistor in a region of nanocomb transistors. The inability to form both nanocomb transistors and extra wide merged nanoribbon-based transistors in the same region may limit performance options.

In accordance with examples described herein, IC structures fabricated using techniques for forming a gate-all-around transistor in a nanocomb-transistor region can enable a hybrid transistor architecture with flexibility in performance options. According to one example, both merged-nanoribbon gate-all-around transistors and nanocomb transistors may be formed by controlling the distance between fins (e.g., the distance between nanoribbon stacks). For example, patterning a stack of alternate layers of a first semiconductor material and a second semiconductor material into fins may involve forming parallel and adjacent fins that are closely-spaced and forming other parallel adjacent fins that are more widely spaced. A dielectric wall/spine material is then deposited over and between the fins, where portions of the dielectric material between the closely-spaced fins merge to form a dielectric wall. The dielectric material can then be removed between the widely-spaced fins. In an example where a nanoribbon (e.g., wide nanoribbon) without a dielectric wall extends in-line with a pair of nanoribbons on either side of a dielectric wall, a "dummy region" may be present between the pair of nanoribbons/dielectric wall and the wide nanoribbon. In one such example, the dummy region may include one or more (e.g., two, three, etc.) isolation regions between the pair of nanoribbons/dielectric wall and the wide nanoribbon.

IC structures as described herein, in particular IC structures fabricated using techniques for forming a gate-all-around transistor in a nanocomb-transistor region as described herein, may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of a radio frequency (RF) receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials, and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 10% of a target value, e.g., within +/- 5% of a target value, based on the context of a particular value as described herein or as known in the art.

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of the presence of IC structures fabricated using techniques for forming a gate-all-around transistor in a nanocomb-transistor region as described herein.

Various aspects of the illustrative implementations will be described using terms commonly employed by those skilled in the art to convey the substance of their work to others skilled in the art. For example, the terms "oxide," "carbide," "nitride," "silicide," etc. refer to compounds containing, respectively, oxygen, carbon, nitrogen, silicon, etc.; the term "high-k dielectric" refers to a material having a higher dielectric constant than silicon oxide; the term "low-k dielectric" refers to a material having a lower dielectric constant than silicon oxide. Materials referred to herein with formulas or as compounds cover all materials that include elements of the formula or a compound, e.g., TiSi or titanium silicide may refer to any material that includes titanium and silicon, WN or tungsten nitride may refer to any material that includes tungsten and nitrogen, etc. The term "insulating" means "electrically insulating," the term "conducting" means "electrically conducting," unless otherwise specified. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices (e.g., physically coupled, conductively coupled, e.g., directly electrically connected). A first component described to be electrically coupled to a second component means that the first component is in conductive contact with the second component (i.e., that a conductive pathway is provided to route electrical signals/power between the first and second components).

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials.

For purposes of illustrating IC structures fabricated using techniques for forming a gate-all-around transistor in a nanocomb-transistor region, described herein, it might be useful to first understand phenomena that may come into play during IC fabrication. The following foundational information may be viewed as a basis from which the present disclosure may be properly explained. Such information is offered for purposes of explanation only and, accordingly, should not be construed in any way to limit the broad scope of the present disclosure and its potential applications.

Non-planar transistors such as double-gate transistors, trigate transistors, FinFETs, nanowire, and nanoribbon transistors refer to transistors having a non-planar architecture. In comparison to a planar architecture where the transistor channel has only one confinement surface, a non-planar architecture is any type of architecture where the transistor channel has more than one confinement surface. A confinement surface refers to a particular orientation of the channel surface that is confined by the gate field. Non-planar transistors potentially improve performance relative to transistors having a planar architecture, such as single-gate transistors.

A gate enclosure of a transistor refers to a portion of the gate stack which sets the amount of a "top-down" space that a gate stack consumes beyond the channel confinement surface. Conventional non-planar transistor architectures all utilize gate enclosures that not only consume space but also add parasitic capacitance, impacting area scaling, speed improvements, and energy savings.

As used herein, the term "nanoribbon" refers to an elongated semiconductor structure having a long axis parallel to a support structure (e.g., a substrate, a chip, or a wafer) over which a transistor arrangement is provided. In some settings, the term "nanoribbon" has been used to describe an elongated semiconductor structure that has a rectangular transverse cross-section (i.e., a cross-section in a plane perpendicular to the longitudinal axis of the structure), while the term "nanowire" has been used to describe a similar structure but with a circular or square-like transverse cross-section. In the present disclosure, the term "nanoribbon" is used to describe both such nanoribbons (including nanosheets) and nanowires, as well as elongated semiconductor structures with a longitudinal axis parallel to the support structures and with having transverse cross-sections of any geometry (e.g., oval, or a polygon with rounded corners). As used herein, the term "face of a nanoribbon" refers to any of the confinement surfaces (i.e., interfaces of the semiconductor material of the nanoribbon with the gate stack) of the nanoribbon which are substantially parallel to the support structure when a nanoribbon extends in a direction parallel to the support structure, while the term "sidewall of a nanoribbon" refers to any of the confinement surfaces of the nanoribbon connecting the bottom face and the top face (the bottom face being the face of the nanoribbon that is closer to the support structure than the top face).

While the descriptions are provided herein with reference to nanoribbons, the principles of IC structures fabricated using techniques for forming a gate-all-around transistor in a nanocomb-transistor region, described herein, are equally applicable to arrangements where a channel material is shaped as a structure where the length of the structure (e.g., a dimension measured along the y-axis of the example coordinate system shown in the present drawings) is similar to the thickness of the structure (e.g., a dimension measured along the z-axis of the example coordinate system shown in the present drawings).

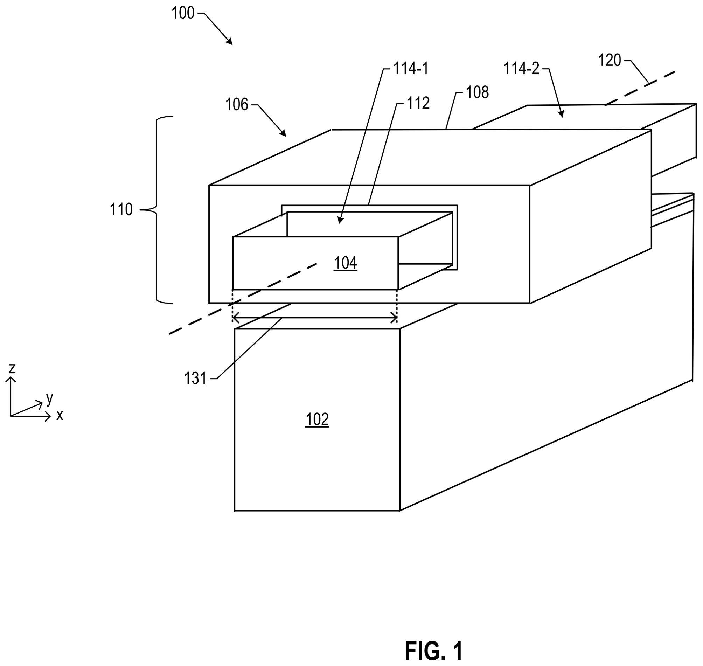

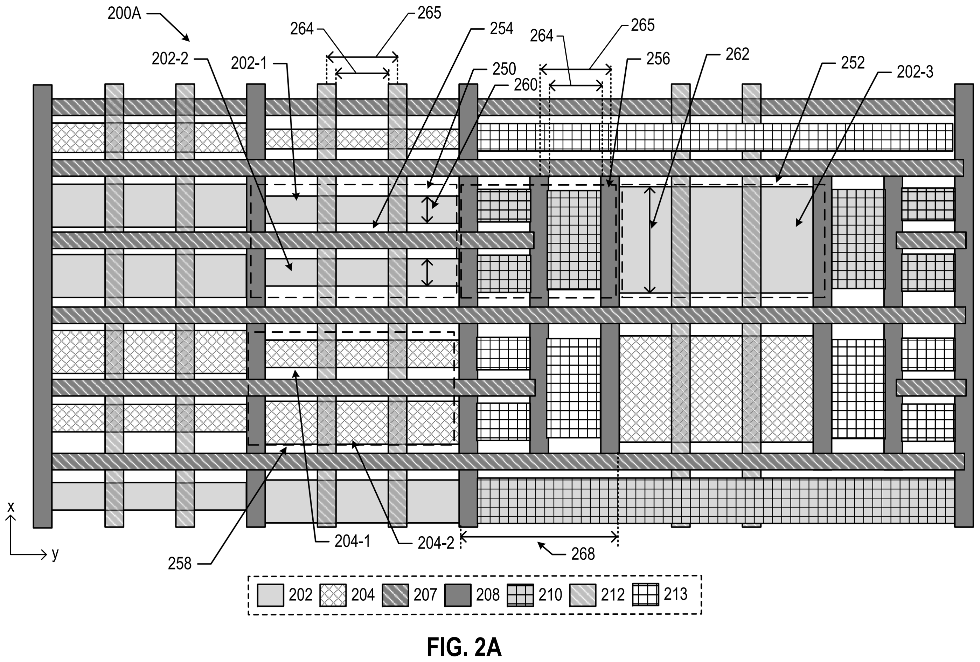

FIG. 1 provides a perspective view of an example IC structure 100 with a nanoribbon transistor 110, according to some embodiments of the present disclosure. For example, in various embodiments, the transistor 110 formed on the basis of a nanoribbon 104, shown in FIG. 1, may be formed on the basis of any of the nanoribbon-based transistor arrangements shown in any of FIGS. 2A-2B, 3A-3E, 10A-10C, and 11. In some of those examples, the nanoribbon-based transistor arrangement is a nanocomb transistor that is formed in the stacks of lateral nanoribbons separated by a dielectric wall. As shown in FIG. 1, the IC structure 100 includes a semiconductor material formed as a nanoribbon 104 extending substantially parallel to a support 102. The transistor 110 may be formed on the basis of the nanoribbon 104 by having a gate stack 106 wrap around at least a portion of the nanoribbon referred to as a "channel portion" and by having source and drain regions, shown in FIG. 1 as a first S/D region 114-1 and a second S/D region 114-2 (referred to herein as simply "S/D regions 114), on either side of the gate stack 106. One of the S/D regions 114 is a source region and the other one is a drain region. However, because, as is common in the field of FETs, designations of source and drain are often interchangeable, they are simply referred to herein as a first S/D region 114-1 and a second S/D region 114-2.

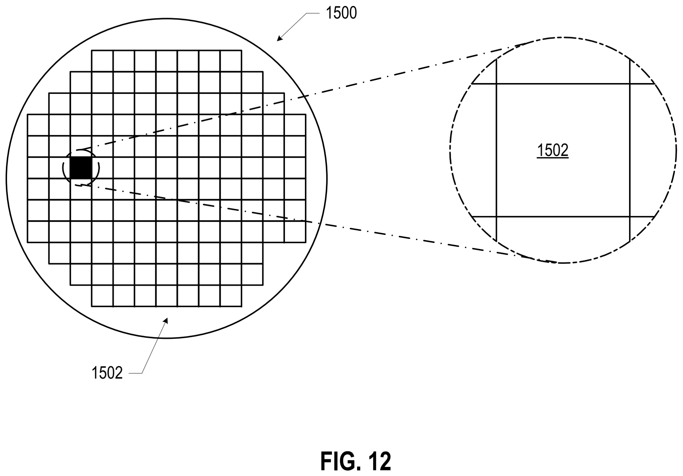

Implementations of the present disclosure may be formed or carried out on any suitable support 102, such as a substrate, a die, a wafer, or a chip. The support 102 may, e.g., be the wafer 1500 of FIG. 12, discussed below, and may be, or be included in, a die, e.g., the singulated die 1502 of FIG. 12, discussed below. The support 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support 102 may be a printed circuit board (PCB) substrate, a package substrate, an interposer, a wafer, or a die. Although a few examples of materials from which the support 102 may be formed are described here, any material that may serve as a foundation upon which an IC structure fabricated using techniques for forming a gate-all-around transistor in a nanocomb-transistor region as described herein may be built falls within the spirit and scope of the present disclosure. Although only one nanoribbon 104 is shown in FIG. 1, the IC structure 100 may include a stack of such nanoribbons where a plurality of nanoribbons 104 are stacked above one another. For example, FIGS. 2A-2B, 3A-3E, 10A-10C, and 11 show IC structures that may be or include examples of the IC structure 100. In some embodiments, a portion of the support 102 right below the lowest nanoribbon 104 of the stack may be shaped as a subfin extending away from a base, as is known in the field of nanoribbon transistors.

The nanoribbon 104 may take the form of a nanowire or nanoribbon, for example. In some embodiments, an area of a transversal cross-section of the nanoribbon 104 (i.e., an area in the x-z plane of an x-y-z coordinate system shown in FIG. 1, perpendicular to a longitudinal axis 120 of the nanoribbon 104) may be between about 25 and 10000 square nanometers, including all values and ranges therein (e.g., between about 25 and 1000 square nanometers, or between about 25 and 500 square nanometers). In some embodiments, a width 131 of the nanoribbon 104 (i.e., a dimension measured in a plane parallel to the support 102 and in a direction perpendicular to the longitudinal axis 120 of the nanoribbon 104, e.g., along the x-axis of the coordinate system) may be at least about 3 times larger than a height or thickness of the nanoribbon 104 (i.e., a dimension measured in a plane perpendicular to the support 102, e.g., along the z-axis of the coordinate system), including all values and ranges therein, e.g., at least about 4 times larger, or at least about 5 times larger. Although the nanoribbon 104 illustrated in FIG. 1 is shown as having a rectangular cross-section, the nanoribbon 104 may instead have a cross-section that is rounded at corners or otherwise irregularly shaped, and the gate stack 106 may conform to the shape of the nanoribbon 104. The term "face" of a nanoribbon may refer to the side of the nanoribbon 104 that is larger than the side perpendicular to it (when measured in a plane substantially perpendicular to the longitudinal axis 120 of the nanoribbon 104), the latter side being referred to as a "sidewall" of a nanoribbon.

In various embodiments, the semiconductor material of the nanoribbon 104 may be composed of semiconductor material systems including, for example, N-type or P-type materials systems. In some embodiments, the nanoribbon 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the nanoribbon 104 may include a combination of semiconductor materials. In some embodiments, the nanoribbon 104 may include a monocrystalline semiconductor, such as silicon (Si) or germanium (Ge). In some embodiments, the nanoribbon 104 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 110 is an N-type metal-oxide-semiconductor (NMOS) transistor), the channel material of the nanoribbon 104 may include a III-V material having a relatively high electron mobility, such as, but not limited to InGaAs, InP, InSb, and InAs. For some such embodiments, the channel material of the nanoribbon 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where the transistor 110 is a P-type metal-oxide-semiconductor (PMOS) transistor), the channel material of the nanoribbon 104 may advantageously be a group IV material having a high hole mobility, such as, but not limited to Ge or a Ge-rich SiGe alloy. For some example embodiments, the channel material of the nanoribbon 104 may have a Ge content between 0.6 and 0.9, and advantageously may be at least 0.7.

In some examples, nanoribbons of the same semiconductor material may be used to form NMOS and PMOS transistors. In such examples, the NMOS and PMOS transistors may be differentiated by depositing N-type or P-type work function metals around channel portions of those transistors.

In some embodiments, the channel material of the nanoribbon 104 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor formed in the nanoribbon is a thin-film transistor (TFT), the channel material of the nanoribbon 104 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, Nor P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material of the nanoribbon 104 may have a thickness between about 5 and 75 nanometers, including all values and ranges therein. In some embodiments, a thin-film channel material may be deposited at relatively low temperatures, which allows depositing the channel material within the thermal budgets imposed on back-end fabrication to avoid damaging other components, e.g., front-end components such as the logic devices.

A gate stack 106 including a gate electrode material 108 and, optionally, a gate insulator material 112, may wrap entirely or almost entirely around a portion of the nanoribbon 104 as shown in FIG. 1, with the active region (channel region) of the channel material of the transistor 110 corresponding to the portion of the nanoribbon 104 wrapped by the gate stack 106. As shown in FIG. 1, the gate insulator material 112 may wrap around a transversal portion of the nanoribbon 104 and the gate electrode material 108 may wrap around the gate insulator material 112.

The gate electrode material 108 may include one or more gate electrode materials, where the choice of the gate electrode materials may depend on whether the transistor 110 is a PMOS transistor or an NMOS transistor. For a PMOS transistor, gate electrode materials that may be used in different portions of the gate electrode material 108 may include, but are not limited to, tungsten, ruthenium, palladium, platinum, cobalt, nickel, and conductive metal oxides (e.g., ruthenium oxide), conductive metal nitrides (e.g., titanium nitride). For an NMOS transistor, gate electrode materials that may be used in different portions of the gate electrode material 108 include, but are not limited to, tungsten, hafnium, zirconium, titanium, tantalum, aluminum, alloys of these metals, and carbides of these metals (e.g., hafnium carbide, zirconium carbide, titanium carbide, tantalum carbide, and aluminum carbide, titanium aluminum carbide). In one example in which both an NMOS transistor and PMOS transistor include gate electrode materials that include tungsten, the gate electrode material including tungsten for the NMOS transistor may include fluorine, and the gate electrode material including tungsten for the PMOS transistor may be fluorine-free (e.g., fluorine may be substantially absent from a gate electrode material including tungsten for a PMOS transistor). In some embodiments, the gate electrode material 108 may include a stack of a plurality of gate electrode materials, where zero or more materials of the stack are workfunction (WF) materials and at least one material of the stack is a fill metal layer. Further materials/layers may be included next to the gate electrode material 108 for other purposes, such as to act as a diffusion barrier layer or/and an adhesion layer.

In some embodiments, the gate insulator material 112 may include one or more high-k dielectrics including any of the materials discussed herein with reference to the insulator material that may surround portions of the transistor 110. In some embodiments, an annealing process may be carried out on the gate insulator material 112 during fabrication of the transistor 110 to improve the quality of the gate insulator material 112. The gate insulator material 112 may have a thickness that may, in some embodiments, be between about 0.5 nanometers and 3 nanometers, including all values and ranges therein (e.g., between about 1 and 3 nanometers, or between about 1 and 2 nanometers). In some embodiments, the gate stack 106 may be surrounded by a gate spacer, not shown in FIG. 1. Such a gate spacer would be configured to provide separation between the gate stack 106 and S/D contacts of the transistor 110 and could be made of a low-k dielectric material, some examples of which have been provided below.

Turning to the S/D regions 114 of the transistor 110, in some embodiments, the S/D regions may be highly doped, e.g., with dopant concentrations of about 10²¹ cm⁻³, in order to advantageously form Ohmic contacts with the respective S/D contacts (not shown in FIG. 1), although these regions may also have lower dopant concentrations and may form Schottky contacts in some implementations. Irrespective of the exact doping levels, the S/D regions of a transistor are the regions having dopant concentration higher than in other regions, e.g., higher than a dopant concentration in the transistor channel (i.e., in a channel material extending between the first S/D region 114-1 and the second S/D region 114-2), and, therefore, may be referred to as "highly doped" (HD) regions. The channel portions of transistors typically include semiconductor materials with doping concentrations significantly smaller than those of the S/D regions 114.

The S/D regions 114 of the transistor 110 may generally be formed using either an implantation/diffusion process or an etching/deposition process. In the former process, dopants such as boron, aluminum, antimony, phosphorous, or arsenic may be ion-implanted into the nanoribbon 104 to form the source and drain regions. An annealing process that activates the dopants and causes them to diffuse further into the nanoribbon 104 may follow the ion implantation process. In the latter process, portions of the nanoribbon 104 may first be etched to form recesses at the locations of the future S/D regions 114. An epitaxial deposition process may then be carried out to fill the recesses with material that is used to fabricate the S/D regions 114. In some implementations, the S/D regions 114 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114 may be formed using one or more alternate semiconductor materials such as germanium or a group III-V material or alloy. And in further embodiments, one or more layers of metal and/or metal alloys may be used to form the S/D regions 114. In some embodiments, a distance between the first and second S/D regions 114 (i.e., a dimension measured along the longitudinal axis 120 of the nanoribbon 104) may be between about 5 and 40 nanometers, including all values and ranges therein (e.g., between about 22 and 35 nanometers, or between about 20 and 30 nanometers).

The IC structure 100 shown in FIG. 1, as well as IC structures shown in other drawings of the present disclosure, is intended to show relative arrangements of some of the components therein, and the IC structure 100, or portions thereof, may include other components that are not illustrated (e.g., electrical contacts to the S/D regions 114 of the transistor 110, additional layers such as a spacer layer around the gate electrode of the transistor 110, etc.). For example, although not specifically illustrated in FIG. 1, a dielectric spacer may be provided between a first S/D contact (which may also be referred to as a "first S/D electrode") coupled to a first S/D region 114-1 of the transistor 110 and the gate stack 106 as well as between a second S/D contact (which may also be referred to as a "second S/D electrode") coupled to a second S/D region 114-2 of the transistor 110 and the gate stack 106 in order to provide electrical isolation between the source, gate, and drain electrodes. In another example, although not specifically illustrated in FIG. 1, at least portions of the transistor 110 may be surrounded in an insulator material, such as any suitable interlayer dielectric (ILD) material. In some embodiments, such an insulator material may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In other embodiments, the insulator material surrounding portions of the transistor 110 may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass.

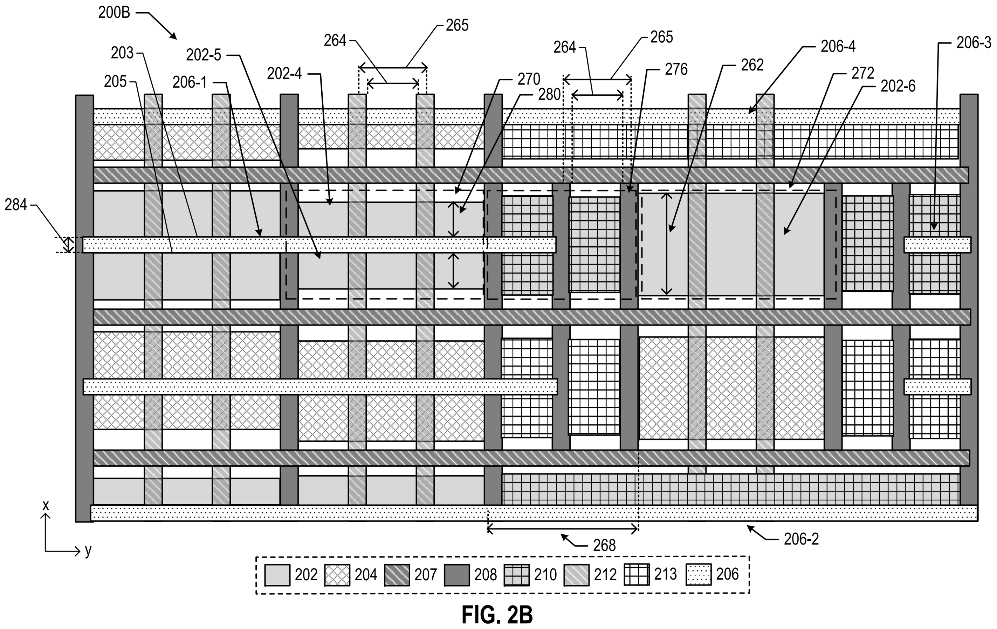

FIGS. 2A-2B are top-down plan views of examples of IC structures including nanoribbon-based transistors, which may be fabricated using techniques for forming a gate-all-around transistor in a nanocomb-transistor region. A number of elements referred to in the description of FIGS. 2A-2B, 3A-3E, 5A-5C, 6A-6C, 7A-7C, 8A-8C, 9A-9C, 10A-10C, and 11 with reference numerals are illustrated in these drawings with different patterns, with a legend showing the correspondence between the reference numerals and patterns being provided at the bottom of each drawing page containing FIGS. 2A-2B, 3A-3E, 5A-5C, 6A-6C, 7A-7C, 8A-8C, 9A-9C, 10A-10C, and 11. For example, the legend illustrates that FIGS. 2A use different patterns to show an N-type nanoribbon 204 and a P-type nanoribbon 202, and so on. FIG. 2A illustrates an example IC structure including gate-all-around transistors with different ribbon widths. FIG. 2B illustrates an example of an IC structure including a gate-all-around transistor in a nanocomb transistor region.

Referring to FIG. 2A, the IC structure 200A includes nanoribbons 202 and 204. The following description refers to the nanoribbons 204 as N-type nanoribbons that form the basis of NMOS transistors and the nanoribbons 202 as P-type nanoribbons that form the basis of PMOS transistors. In some examples, the N-type and P-type nanoribbons 204, 202 may have the same or substantially the same material composition. In one such example, the NMOS and PMOS transistors may be distinguished from one another based on the presence of one or more different gate electrode materials in their respective gate stacks. In some examples, the N-type and P-type nanoribbons 202 and 204 may have different material compositions. The nanoribbons 202, 204 may represent one or more nanoribbons stacked over one another (e.g., one, two, three, four, five, or more than five nanoribbons stacked over one another). In the example illustrated in FIG. 2A, the nanoribbons 202 and 204 extend along the y-axis.

FIG. 2A also illustrates regions extending orthogonally to the nanoribbons 202, 204; specifically, metal gate lines 212 may extend substantially perpendicular to the nanoribbons 202 and 204 and substantially parallel to one another, e.g., along the x-axis shown in FIG. 2A. Metal gate lines 212 and the S/D contact lines (not shown in FIG. 2A) may be provided in an alternating manner. Metal gate lines 212 may intersect gate contacts that are in conductive contact with the gate stacks 106 (not visible in the view of FIG. 2A) provided over channel portions of the nanoribbons 202 and 204, providing electrical connectivity to the gates of the nanoribbon transistors. Thus, portions of the gate contacts intersecting the gate stacks 106 are in conductive contact with the gate stacks 106 and serve as gate contacts for the transistors. The lines 207 represent locations in which the metal gate lines 212 may have been cut to electrically/conductively isolate metal gate portions from one another. In some examples, one or more metal gate lines 212 may not be cut in the regions indicated by the lines 207. One or more isolation lines, such as the isolation region 208, may also be present in the IC structure. In one example, such isolation lines may be substantially parallel with the metal gate lines 212 and substantially orthogonal to the nanoribbons 202 and 204. The isolation regions 208 may represent regions of an insulator material that electrically/conductively isolate adjacent structures from one another, such as adjacent nanoribbon portions and/or adjacent S/D regions.

As mentioned briefly above, circuit design may be done using cells from a library. For example, the boundaries of a cell (e.g., a standard/single height cell or double height cell) may be located at or between the boundary between an N-type diffusion region and a P-type diffusion region (e.g., between or at a boundary between an N-type nanoribbon and P-type nanoribbon), or between two N-type nanoribbons or between two P-type nanoribbons. As can be seen in FIG. 2A, the IC structure 200A includes nanoribbons 202, 204 with different widths (where the width of a nanoribbon is a dimension of the nanoribbon along the x-axis shown in FIG. 2A). For example, the region 250 includes two parallel adjacent nanoribbons 202-1, 202-2 separated by a gap 254, where the nanoribbons 202-1 and 202-2 have a width 260. In one such example, the nanoribbons 202-1, 202-2 may be in one cell (e.g., a double height cell or other larger/multiple height cell), or may each be in different cells (e.g., two standard height cells). The region 252 includes a nanoribbon 202-3 with a width 262 that is greater than the width 260. The nanoribbon 202-3 is an example of a merged nanoribbon (e.g., double height merged nanoribbon) in which the space occupied by the gap 254 is utilized to form an extra wide nanoribbon. As can be seen in FIG. 2A, the nanoribbon 202-3 has a width 262 as if two nanoribbons were merged together. For example, the nanoribbon 202-3 may occupy the space (e.g., width) similar to the nanoribbons 202-1 and 202-2 and some or all of a space (or dielectric wall, as explained below with reference to FIG. 2A) between the nanoribbons 202-1, 202-2. The wide nanoribbon 202-3 may be the basis in which higher performance transistors are formed. The ratio of active regions to dead space may also be improved in the region 252 compared to a region without a merged nanoribbon along the same nanoribbon path as the nanoribbons 202-1 and 202-2.

In some examples, a transition region may be present between a region with multiple narrower nanoribbons and a wider merged nanoribbon. For example, the IC structure 200A includes a transition region 256 between the regions 250 and 252. The transition region 256 may include one or more isolation regions 208. In the example illustrated in FIG. 2A, the transition region 256 includes three isolation regions 208, where a semiconductor material 210 is between adjacent isolation regions 208, and where the isolation regions 208 physically and conductively separate device elements in the regions 250 and 252 from the semiconductor material 210 in the transition region 256. Thus, the transition region 256 may include nanoribbon portions of the semiconductor material 210, however, those semiconductor regions are inactive (e.g., the region 256 is a dummy region that lacks active transistors). Thus, the region 256 represents a transition or dummy region that includes a P-type semiconductor region between isolation regions. Similarly, the IC structure depicts a transition or dummy region that includes an N-type semiconductor region (the semiconductor material 213) between isolation regions 208. In other examples, adjacent parallel nanoribbons may have different widths. For example, the region 258 includes a nanoribbon 204-1 with a smaller width than the adjacent parallel nanoribbon 204-2.

In the example illustrated in FIG. 2A, the isolation regions 208 and metal gate lines 212 are spaced at substantially regular intervals such that the distance between a given two adjacent metal gate lines 212 (or between two adjacent isolation regions 208 or between a metal gate line and an adjacent isolation region 208) is about the same. For example, FIG. 2A depicts the distance 264 between two adjacent metal gate lines 212. FIG. 2A also depicts the pitch 265 between two metal gate lines, where the pitch is a measurement of the distance between an approximate middle of one line and the approximate middle of an adjacent line. Similarly, in the example illustrated in FIG. 2A, adjacent isolation regions 208 (e.g., in the region 256) are separated by a distance 264 and have a pitch 265.

Accordingly, the example illustrated in FIG. 2A in which the region 256 (e.g., transition/dummy region) has three isolation regions 208, the length 268 of the region 256 spans the distance of about two times the pitch 265 of the metal gate lines 212, where the length 268 of the region 256 is a dimension of the region 256 in a plane substantially parallel with the device region and parallel with the nanoribbons 202, 204. In the example shown in FIG. 2A, the length 268 is shown as being measured from the outer edges of the isolation regions in a cross-section along a plane substantially parallel with the device region (e.g., in the x-y plane shown in FIG. 2A). Thus, the length 268 may be a dimension of the region 256 from the edge of one isolation region 208 to the edge of another isolation region 208, where the length 268 is equal to about two times the pitch 265 plus the width of one of the isolation regions 208. In other examples, the length 268 may be different than shown in FIG. 2A. For example, the region 256 may include one or two isolation regions 208 instead of three isolation regions 208, or may include more than three isolation regions 208. Additionally, although the isolation regions 208 are depicted as having about the same width as the metal gate lines 212, the isolation regions 208 may have a different width than the metal gate lines 212. Furthermore, although the isolation regions 208 are shown as having about the same pitch as the metal gate lines 212, in other examples, one or more isolation regions may have locations and/or widths that do not correspond to the pitch of the metal gate lines 212. For example, the region 256 may include one wider isolation region in which more or all of the nanoribbon material has been removed and filled with an insulator material.

FIG. 2B illustrates another top-down plan view of an example of an IC structure 200B including nanoribbon-based transistors, which may be fabricated using techniques for forming a gate-all-around transistor in a nanocomb-transistor region. The IC structure 200B is similar to the IC structure 200A in that it includes nanoribbons 202 and 204 of different widths extending parallel with one another. One difference between the IC structure 200B and the IC structure 200A is that the IC structure 200B includes dielectric walls 206 (e.g., spines) between some of the adjacent nanoribbon pairs. For example, the IC structure 200B includes a region 270 in which a dielectric wall 206-1 is present in the stack of P-type nanoribbons 202. The dielectric wall 206-1 (which may also be referred to as a spine, backbone, or dielectric region) may be a portion of a dielectric material that may be shaped like a wall, and which extends substantially orthogonally from the substrate. The dielectric wall 206-1 may extend through the stack of nanoribbons 202 in the region 270, such that portions of the nanoribbons 202 on either side of the dielectric wall 206 may be referred to as separate stacks of nanoribbons. For example, the nanoribbon 202-4 is coupled with a first face or side 203 of the dielectric wall 206-1 and the nanoribbon 202-5 is coplanar with the nanoribbon 202-4 and coupled with a second face or side 205 of the dielectric wall 206-1. The presence of the dielectric wall 206-1 coupled with the nanoribbons 202-4, 202-5 may enable the nanoribbons 202-4, 202-5 to have a greater width 280 than may be possible with a gap between the adjacent nanoribbons. The nanoribbons 202-4, 202-5, and the dielectric wall 206-1 may form the basis of one or more nanocomb transistors in the region 270.

The IC structure 200B also includes a region 272 in which the dielectric wall is absent. In the example illustrated in FIG. 2B, the nanoribbons 202-4, 202-5 in the region 270 each have a width 280, and the nanoribbon 202-6 in the region 272 has a width 262. The dielectric wall 206-1 has a width 284. In the example illustrated in FIG. 2B, the width 262 of the nanoribbon 202-6 is greater than or equal to the width 280 of the nanoribbon 202-4 plus the width 280 of the nanoribbon 202-5 (e.g., greater than or equal to about twice the width 280). In the example illustrated in FIG. 2B, the width 262 of the nanoribbon 202-6 is about the same as the combined width of the nanoribbons 202-4 and 202-5 and the width 284 of the dielectric wall 206-1. In other examples, the width 262 of the nanoribbon 202-6 may be smaller than the combined width of the nanoribbons 202-4, 202-5 and the dielectric wall 206-1 (e.g., smaller than the width 280 plus the width 280 plus the width 284). Like the example shown in FIG. 2A, the IC structure 200B also includes a region 276 (e.g., transition/dummy region) between the region 270 and the region 272. In the example illustrated in FIG. 2B, the dielectric wall 206-1 partially extends into the region 276. For example, the dielectric wall 206-1 is present in the semiconductor material 210 between isolation regions 208. In the example illustrated in FIG. 2B, the dielectric wall 206-1 does not extend entirely across the region 276, but instead stops at or before the second isolation region 208 in the region 276 (e.g., the dielectric wall 206-1 stops, and is therefore absent from, the semiconductor material 210 and isolation region 208 that are closest to the region 272 with the merged nanoribbon).

The region 272 without a dielectric wall may form the basis of one or more gate-all-around transistors. The region 272 is surrounded by regions with dielectric walls. For example, the region 270 includes nanoribbons 202-4, 202-5 coupled with and on either side of a dielectric wall 206. The IC structure 200B further includes a dielectric wall 206-3 on the opposite side of the region 272 from the dielectric wall 206-1. In the example illustrated in FIG. 2B, the dielectric walls 206-3 and 206-1 extend along the same line, and the region 272 (and therefore the nanoribbon 202-6) is between the dielectric wall 206-3 and the dielectric wall 206-1. The region 272 (and therefore nanoribbon 202-6) is also between dielectric walls 206-2 and 206-4. Thus, the nanoribbon 202-6 in the region 272 is surrounded on four sides by nanoribbons adjacent to and coupled with dielectric walls. Therefore, a gate-all-around transistor with a channel region in the nanoribbon 202-6 may be surrounded on four sides by nanocomb transistors having channel regions in nanoribbons that are coupled with the dielectric walls 206-1, 206-2, 206-3, and 206-4. In other examples, a gate-all-around transistor may be bordered by nanocomb transistors on fewer than four sides (e.g., one side, two sides, or three sides).

Thus, FIGS. 2A and 2B illustrate examples of IC structures that may be fabricated using techniques for forming a gate-all-around transistor in a nanocomb-transistor region. Although FIG. 2A does not depict nanocomb transistors, similar techniques may be utilized to fabricate the IC structures 200A and 200B with and without nanocomb transistors, respectively.

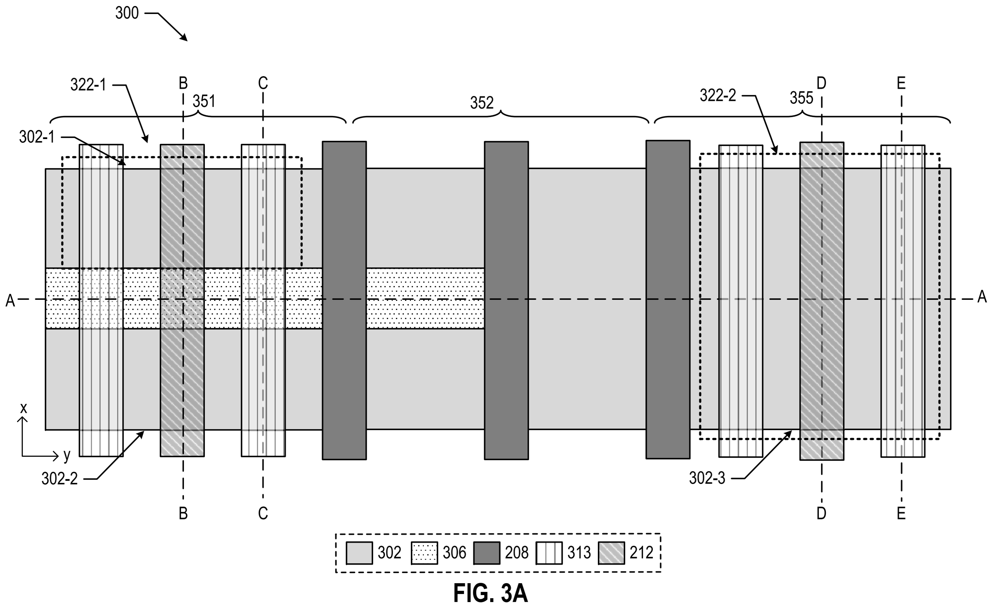

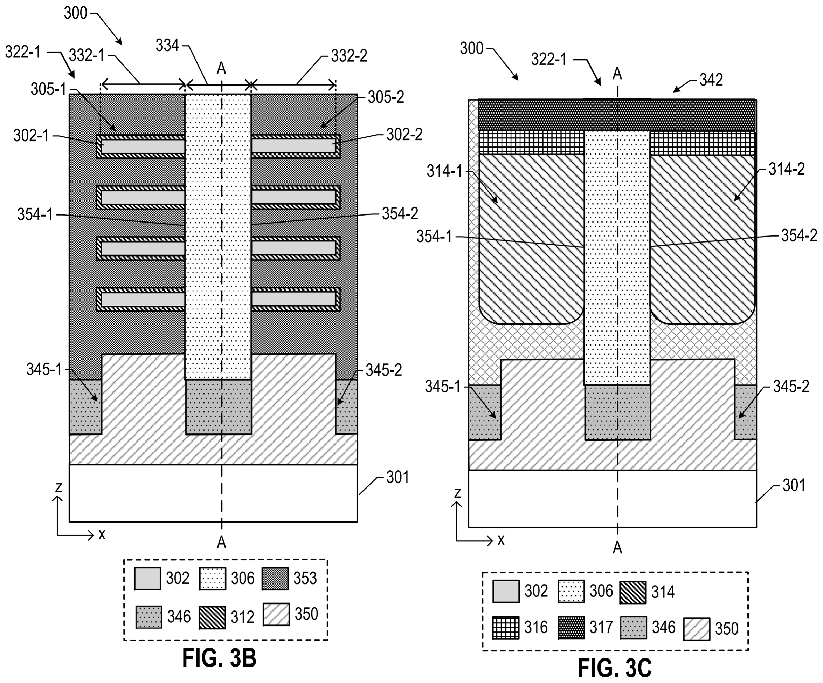

FIGS. 3A-3E illustrate different cross-sectional views of an example of an IC structure fabricated using techniques for forming a gate-all-around transistor in a nanocomb-transistor region. FIG. 3A illustrates a top down plan view of an IC structure 300. FIGS. 3B-3E illustrate different cross-sections in the x-z plane of the example coordinate system shown in FIG. 3A along planes BB, CC, DD, and EE, respectively, shown in FIG. 3A.

Turning to FIG. 3A, the top-down view of the IC structure 300 is similar to the view in FIGS. 2A-2B. The IC structure 300 includes a nanoribbon or stack of nanoribbons 302 extending along the y-axis shown in FIG. 3A. Similar to FIGS. 2A-2B, the IC structure includes metal gate lines 212 and isolation regions 208. The IC structure 300 also includes S/D contact lines 313. The IC structure 300 includes a dielectric wall 306 in the region 351. For example, the region 351 includes a first nanoribbon 302-1 and a second nanoribbon 302-2 separated by the dielectric wall 306. The first nanoribbon 302-1 may form the basis of a first nanoribbon transistor and the second nanoribbon 302-2 may form the basis of a second nanoribbon transistor. The region 355 includes a wide (e.g., merged) nanoribbon 302-3. In one such example, the wide nanoribbon 302-3 in the region 355 extends along the same axis as the dielectric wall 306, along the same axis as the nanoribbon 302-1, and along the same axis as the nanoribbon 302-2. Nanocomb transistors may be formed in the nanoribbons 302 in the region 351. For example, the approximate location of an example nanocomb transistor 322-1 is shown with a dotted-line box in the region 351, where the nanocomb transistor 322-1 is adjacent to and coupled with the dielectric wall 306. In contrast, the region 355 lacks the dielectric wall 206. Therefore, in the region 355, nanoribbon-based transistors formed in the nanoribbon 302-3 may be gate-all-around transistors, where a dielectric wall 306 is absent from between such transistors. For example, the approximate location of a gate-all-around nanoribbon-based transistor 322-2 is shown with a dotted-line box in the region 355. Thus, in the example illustrated in FIG. 3A, a transistor having an extra wide nanoribbon width (e.g., the transistor 322-2) may be formed along the same nanoribbon path as a nanocomb transistor 322-1. A region 352 may be an inactive or dummy region between the nanocomb transistor 322-1 and the gate-all-around transistor 322-2. The region 352 may lack active transistors. The region 352 may lack conductive connection to metal lines (e.g., interconnects configured to provide power or transmit signals) of metallization stacks of the final structure. Like in the examples illustrated in FIG. 3A, the region 352 includes three isolation regions 208 and regions of the semiconductor material of the nanoribbons 302 between the adjacent isolation regions 208.

FIG. 3B illustrates a cross-sectional view of the IC structure 300 along the plane BB shown in FIG. 3B. The view in FIG. 3B illustrates a gate view of a nanocomb transistor 322-1 in which a conductive material 353 (e.g., gate electrode material) at least partially surrounds portions of the nanoribbons 302. The IC structure 300 includes transistors similar to the transistor 110 but built on the basis of nanoribbon stacks of a plurality of nanoribbons instead of just one nanoribbon 104 as shown in FIG. 1. Specifically, the cross-section illustrated in FIG. 3B depicts a stack of nanoribbons 302 of a semiconductor material over a substrate 301. The substrate may be an example of the support 102 of FIG. 1. The IC structure 300 illustrated in FIG. 3B includes a dielectric-filled trench (e.g., a dielectric wall 306) in the stack of nanoribbons 302. The stack may thus be referred to as two adjacent stacks of nanoribbons 302 (e.g., the stack 305-1 and the stack 305-2) on either side of the dielectric wall 306. While four nanoribbons 302 are shown to be included in each of the nanoribbon stacks 305-1, 305-2, in other embodiments, fewer nanoribbons 302 or more nanoribbons 302 may be included (e.g., two nanoribbons, three nanoribbons, five nanoribbons, etc.).

The dielectric wall 306 is over and substantially orthogonal to the substrate 301, where the dielectric wall has a first side 354-1 and a second side 354-2 opposite the first side 354-1. In the example illustrated in FIG. 3B, the dielectric wall 306 has a width 334 (where the width 334 is a dimension of the dielectric wall 306 in a plane substantially parallel with the substrate 301). Nanoribbons of the stack 305-1 (e.g., the nanoribbon 302-1) are coupled with the first side 354-1 of the dielectric wall 306 and nanoribbons of the stack 305-2 (e.g., the nanoribbon 302-2) are coplanar with the corresponding nanoribbons of the first stack 305-1 and coupled with the second side 354-2 of the dielectric wall 306. The nanoribbons of the stack 305-1 have a width 332-1 (where the width 332-1 is a dimension of the nanoribbon 302-1 in a plane substantially parallel with the substrate 301 and extending away from the first side 354-1), and the nanoribbons of the stack 305-2 have a width 332-2 (where the width 332-2 is a dimension of the nanoribbon 302-2 extending away from the second side 354-2).

The IC structure also includes subfins 345-1, 345-2, including a first subfin 345-1 below and substantially aligned with the first stack 305-1 of nanoribbons 302 and a second subfin 345-2 below and substantially aligned with the second stack 305-2 of nanoribbons 302. The subfins 345-1, 345-2 in FIG. 3B are shown as including subfin replacement structures of an insulator material 350; however, in other examples, the subfins 345-1, 345-2 may include subfin structures that include the semiconductor material of the nanoribbons 302 and/or include semiconductor materials of different material compositions. In the example illustrated in FIG. 3B, another insulator material 346 lines the STI region between the subfins 345-1, 345-2. In some examples, the insulator material 346 and/or the insulator material 312 may be an oxide (e.g., silicon oxide, silicon oxynitride, carbon-doped silicon oxide, carbon-doped silicon oxynitride, or another suitable insulator material including oxygen). A gate stack having a gate insulator material 312 and a gate electrode material 353 wraps at least partially around channel portions of the nanoribbons 302.

FIG. 3C illustrates an example cross-sectional view of the IC structure 300 along the plane CC shown in FIG. 3A. FIG. 3C illustrates an S/D region of a doped semiconductor material. Specifically, the IC structure includes a first S/D region 314-2 in the first nanoribbon stack 305-1 and a second S/D region 314-2 in a second nanoribbon stack 305-2, where the S/D region 314-1 is coupled with the side 354-1 of the dielectric wall 306 and the S/D region 314-2 is coupled with the side 354-2 of the dielectric wall 306. The S/D regions 314-1, 314-2 represent regions of a doped semiconductor material, and may be examples of the S/D regions 114 discussed above. One of the S/D regions 314-1 and 314-2 may be a source region or a drain region of one nanocomb transistor (e.g., the transistor 322-1), and another of the S/D regions 314-1 and 314-2 may be a source region or a drain region of another nanocomb transistor.

The IC structure 300 includes an S/D contact structure 342 that include a conductive material 317 for making electrical contact with the S/D regions 314-1, 314-2. FIG. 3C illustrates an IC structure 300 with front-side contact structures, however, in other examples, one or more contact structures may be formed from a back side of the wafer or IC structure instead of or in addition to front-side contact structures. At the bottom of the S/D contact structure 342, an interface material 316 may be provided as an interface between the S/D regions 314-1, 314-2 and the electrically conductive fill material 317 of S/D contact structure 342. The interface material 316 may include/be a metal such as titanium which, once deposited, may intermix with the material of the S/D regions 314, e.g., with silicon, forming a compound (e.g., titanium silicide) that may help reduce contact resistance between the S/D regions 314 and the S/D contact structure 342.

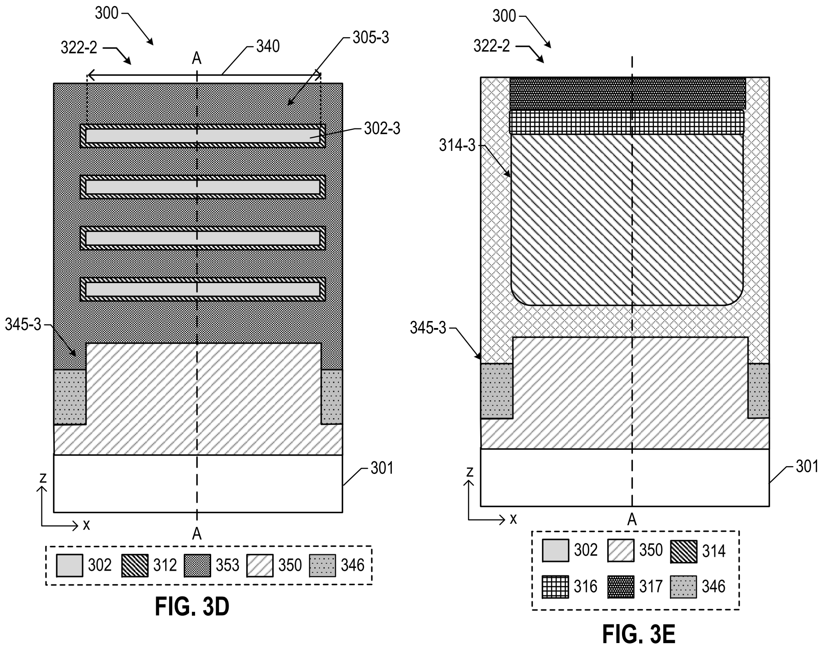

Thus, FIGS. 3B and 3C represent cross-sectional views in two different planes of an example IC structure including a nanocomb transistor 322-1. FIGS. 3D and 3E illustrate cross-sectional views of an example merged nanoribbon transistor in the same nanoribbon path as the nanocomb transistor of FIGS. 3B-3C. For example, referring to FIG. 3A, FIG. 3D illustrates a cross-sectional view along the plane DD in the region 355 and FIG. 3E illustrates a cross-sectional view along the plane EE in the region 355.

Turning to FIG. 3D, The view in FIG. 3D illustrates a gate view of a transistor 322-2 in which a conductive material 353 (e.g., gate electrode material) at least partially surrounds portions of the nanoribbons 302 of the wide stack 305-3. The IC structure 300 includes a subfin 345-3 below the stack 305-3 of nanoribbons. In the illustrated example, the stack 305-3 includes nanoribbons of a semiconductor material (e.g., the nanoribbon 302-3) that are coplanar with and parallel with the nanoribbons of the stacks 305-1 and 305-2 (e.g., as shown in FIG. 3B). For example, the nanoribbon 302-3 is substantially coplanar and parallel with the nanoribbons 302-1 and 302-3. In one example, the nanoribbons 302 of the stack 305-3 have a width 340 that is greater than or equal to the width 332-1 plus the width 332-2. Turning now to FIG. 3E, the view of the IC structure 300 in the plane EE illustrates one S/D region 314-3 (e.g., either a source region or a drain region) for the transistor 322-2. Thus, the transistor 322-2 illustrated in FIGS. 3D-3E is similar to the transistor 322-1 illustrated in FIGS. 3B-3C, except the transistor 322-1 is adjacent to and coupled with the dielectric wall 306 and transistor 322-2 is not coupled with a dielectric wall. Additionally, the transistor 322-2 has a channel region in a stack 305-3 of nanoribbons that are wider than the nanoribbons 302-1 and 302-2.

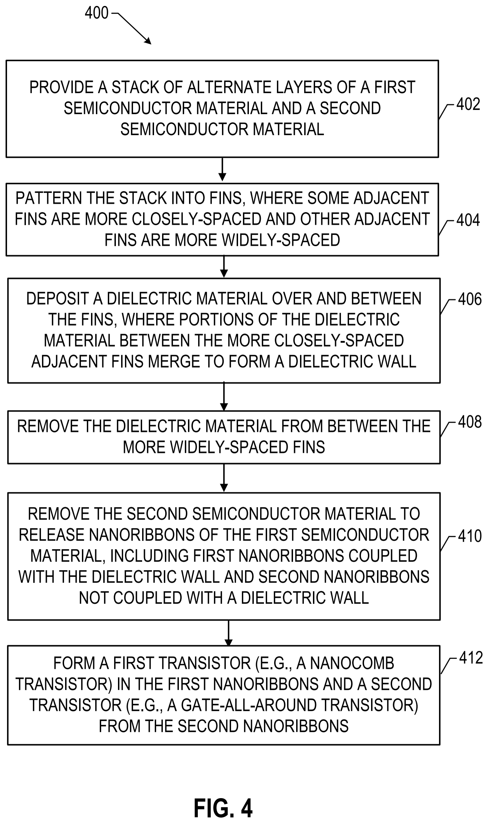

FIG. 4 is a flow diagram of an example method for fabricating an IC structure using techniques for forming a gate-all-around transistor in a nanocomb-transistor region, in accordance with some embodiments.

Although the operations of the method of FIG. 4 are illustrated once each and in a particular order, the operations may be performed in any suitable order and repeated as desired. For example, one or more operations may be performed in parallel to fabricate multiple IC structures fabricated using techniques for forming a gate-all-around transistor in a nanocomb-transistor region substantially simultaneously. In another example, the operations may be performed in a different order to reflect the structure of an IC structure fabricated using techniques for forming a gate-all-around transistor in a nanocomb-transistor region.

In addition, the example fabricating method of FIG. 4 may include other operations not specifically shown in FIG. 4, such as various cleaning or planarization operations as known in the art. For example, in some embodiments, a support, as well as layers of various other materials subsequently deposited thereon, may be cleaned prior to, after, or during any of the processes of the methods described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the intermediate IC structures described herein may be planarized prior to, after, or during any of the processes of the method of FIG. 4 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

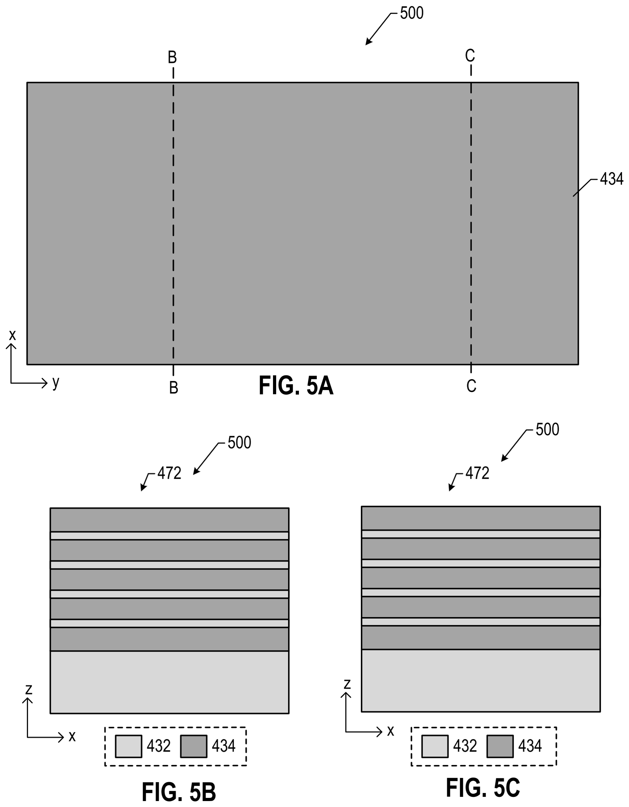

FIGS. 5A-5C, 6A-6C, 7A-7C, 8A-8C, 9A-9C, and 10A-10C provide cross-sectional side views at various stages in the fabrication of an example IC structure according to the method of FIG. 4, in accordance with some embodiments. The figures of FIGS. 5A-5C, 6A-6C, 7A-7C, 8A-8C, 9A-9C, and 10A-10C that are labeled with the letter A (e.g., FIG. 5A) illustrate top-down views in the x-y plane. The figures of FIGS. 5A-5C, 6A-6C, 7A-7C, 8A-8C, 9A-9C, and10A-10C that are labeled with the letter B (e.g., FIG. 5B) illustrate cross-sectional side views in the y-z plane along a plane BB shown in the corresponding figure labeled with a letter A (e.g., in FIG. 5A). The figures of FIGS. 5A-5C, 6A-6C, 7A-7C, 8A-8C, 9A-9C, and10A-10C that are labeled with the letter C (e.g., FIG. 5C) illustrate cross-sectional side views in the y-z plane along a plane CC shown in the corresponding figure labeled with a letter A (e.g., in FIG. 5A).

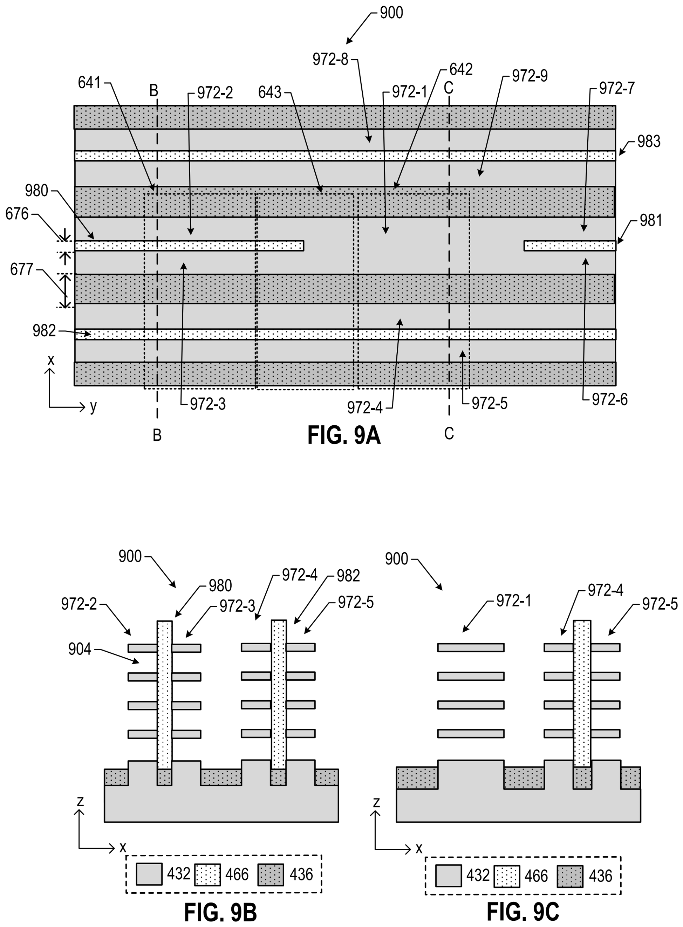

Turning to FIG. 4, the method 400 begins with a process 402 of providing a stack of alternate layers of a first semiconductor material and a second semiconductor material. The IC structure 500 of FIGS. 5A-5C is an example resulting IC structure of the process 402. The IC structure 500 includes alternating layers of a semiconductor material 432 and layers of another material 434. While FIGS. 5A-5C illustrate five layers of the semiconductor material and four layers of the material 434 in a stack 472, in other embodiments, any other number of layers may be used as long as they are alternating and include at least three layers of the semiconductor material 432 and at least two layers of the material 434. The upper layers of the semiconductor material 432 will later be formed into nanoribbons stacked above one another, as shown in FIGS. 9B-9C, discussed below. Thus, although a particular number of nanoribbons formed of the upper layers of the semiconductor material 432 is depicted in FIGS. 9B-9C (namely, four nanoribbons), embodiments of the present disclosure include IC structures having more or fewer stacked nanoribbons than depicted.

As shown in FIGS. 5A-5C, in some embodiments, the alternation of layers of the semiconductor material 432 and the material 434 may begin after a bottom layer of the semiconductor material 432. In one such example, the bottom layer of the semiconductor material 432 may later form a subfin under the stack of nanoribbons. Although the thickness of the bottom layer of the semiconductor material 432 is depicted as being greater than the subsequent layers of the semiconductor material 432 that are formed into nanoribbons via further processing, in other examples, the bottom layer of the semiconductor material 432 may have a substantially same thickness as another layer of the semiconductor material 432.

The semiconductor material 432 may be any of the semiconductor/channel materials described above with reference to the nanoribbon 104 of FIG. 1. The material 434 may be any suitable material that is etch-selective with respect to the semiconductor material 432 so that, in a later process, the material 434 may be etched away to form nanoribbons of the semiconductor material 432. As known in the art, two materials are said to be "etch-selective" (or said to have "sufficient etch selectivity") with respect to one another when etchants used to etch one material do not substantially etch the other, enabling selective etching of one material but not the other. For example, in some embodiments, the semiconductor material 432 may be silicon while the material 434 may be a second semiconductor material such as silicon germanium. In another example, the semiconductor material 432 may be silicon germanium, while the material 434 may be silicon. In other examples, the material 434 may be made of a non-semiconductor material, e.g., of an insulator material, as long as this material is sufficiently etch-selective with respect to the semiconductor material 432.

Thus, the material 434 may be any suitable sacrificial material that is etch-selective with respect to the semiconductor material 432. Selecting the material 434 to be a semiconductor material may be particularly advantageous because it may improve the quality of the semiconductor material 432 if the semiconductor material 432 is epitaxially grown on the material 434. In some embodiments, the process 402 may include epitaxially growing layers of the semiconductor material 432 and the material 434 (e.g., a second semiconductor material) in an alternating manner. In other embodiments, alternate layers of the semiconductor material 432 and the material 434 may be provided in the process 402 using other techniques, such as layer transfer or thin-film deposition. Although FIGS. 5A-5C illustrates the same semiconductor material 432 in various layers of the IC structure 500, in general, material compositions of a semiconductor material from which nanoribbons will later be formed in different layers of the IC structure 500 may be different. For example, the semiconductor material 432 of one layer of the IC structure 500 may be silicon while the semiconductor material 432 of another layer of the IC structure 500 may be a III-N semiconductor material such as GaN.

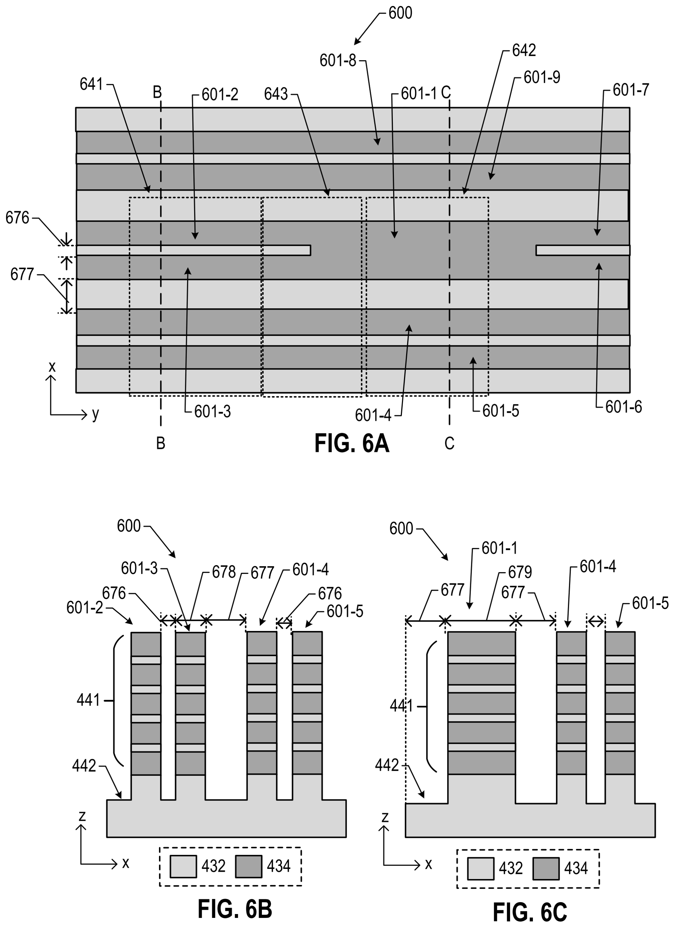

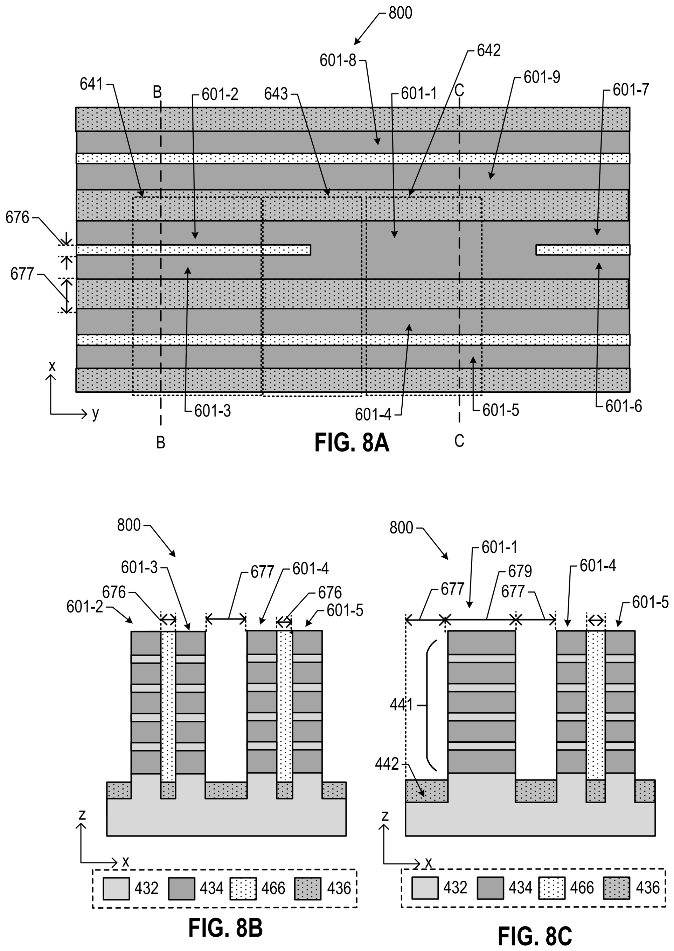

The method 400 continues with a process 404 of patterning the stack into fins, where some adjacent fins are more closely-spaced and other adjacent fins are more widely-spaced. FIGS. 6A-6C illustrate an example of an IC structure 600 resulting from the process 404. The IC structure 600 illustrates that the stack 472 of alternating layers of the semiconductor material 432 and the material 434, has been patterned into fins 601-1-601-9 (e.g., fins 601-1, 601-2, 601-3, 601-4, 601-5, 601-6, 601-7, 601-8, and 601-9). FIG. 6A includes regions 641, 642, and 643, and FIGS. 6B and 6C illustrate cross-sectional views of the regions 641 and 642 along the BB and CC planes, respectively. The region 643 represents a transition region between the region 641 and the region 642. Each of the fins 601-1-601-9 may include an active portion 441 and a subfin 442. The active portions 441 may be a portion of the fins 601-1-601-9 from which the respective nanoribbons will be formed, while the subfin 442 is a portion of the fins 601-1-601-9 that will have sidewalls at least partially enclosed with an insulator material 436, e.g., as shown in FIGS. 8A-8C, discussed below.

Thus, the fins 601-1-601-9 may be shaped as structures that extends away from a support or subfin region (e.g., which may include a subfin 442 at the bottom). In some embodiments, the subfin 442 may include the bottom layer of the semiconductor material 432, as well as an upper portion of a support. In some embodiments, semiconductor material 432 of the subfin 442 may be removed and/or replaced with one or more other materials in subsequent processes.

As can be seen in FIGS. 6A-6C, some of the fins 601-1-601-9 have different widths and the spacing between some fins is greater than the spacing between other fins. For example, the region 641, shown in FIG. 6B, includes adjacent fins 601-2 and 601-3, which are separated from one another by a distance 676. The region 641 also includes the adjacent fins 601-4 and 601-5, which are separated from one another by the distance 676. The fin 601-4 is adjacent to the fin 601-3, and the fins 601-4 and 601-3 are separated from one another by a distance 677, which is greater than the distance 676. The distance 676 is sufficiently small enough so that portions of a dielectric material deposited, in a subsequent process, on sidewalls between the closely-spaced fins (e.g., between fins 601-2 and 601-3) will merge together to form a dielectric wall. The distance 677 is sufficiently larger than the distance 676 so that portions of the dielectric material deposited on sidewalls between the more widely-spaced fins will not merge. In some examples, the distance 677 may be about 1.1-3 times greater, about 1.1-1.5 times greater, 1.1-1.3 times greater, or about 1.1-1.2 times greater than the distance 676. In some examples, the distance 676 is in a range of about 5-25 nanometers and the distance 677 is in a range of about 5.5-30 nanometers. Although FIGS. 6A-6C illustrate an example in which the more widely-spaced fins are separated by the same distance 677, in other examples, the fins may be separated by different distances (e.g., the distance between the two adjacent widely-spaced fins may be different).

In some embodiments, the fins 601-2, 601-3, 601-4, and 601-5 each have a width 678 (i.e., a dimension of the fin measured along the x-axis of the example coordinate system shown in FIGS. 6A-6C). The width of the fin may be that of the width of the nanoribbons subsequently formed (e.g., the nanoribbon 104 of FIG. 1 described above). The fins 601-2, 601-3, 601-4, and 601-5 may further have a length (i.e., a dimension of the fins 601-2, 601-3, 601-4, and 601-5 measured along the y-axis of the example coordinate system shown in FIGS. 6A-6C) suitable to account for the length of the future nanoribbons (e.g., as described above with reference to the length of the nanoribbon 104 of FIG. 1).

The region 642, shown in FIG. 6C, includes a fin 601-1 along the same axis or line as the fin 601-2 and along the same axis or line as the fin 601-3. The fin 601-1 is spaced from adjacent fins by a distance 677. Thus, the spacing between the fin 601-1 and the adjacent fin 601-4 is sufficiently great that a dielectric wall will not be formed between the fins 601-1 and 601-4. Similarly, the fin 601-1 is at a distance 677 from an adjacent fin on the opposite side of the fin 601-1 (e.g., the fin 601-9 shown in FIG. 6A). Thus, due to the spacing, a dielectric wall will not be formed adjacent to the fin 601-1, and a gate-all-around transistor can be formed in the nanoribbons subsequently formed from the fin 601-1. The fin 601-1 has a width 679 that is greater than the width 678 of the fins 601-2 and 601-3. As can be seen in FIG. 6A, width 679 of the fin 601-1 is about the same as the combined width of the fins 601-2 and 601-3 plus the distance between the fins 601-2 and 601-3. Thus, the fin 601-1 can be considered a merged nanoribbon (e.g., because it occupies about the same amount of area as the two fins 601-1 and 601-2).

In various embodiments, any suitable patterning techniques may be used to form the fins 601-1-601-9, such as, but not limited to, photolithographic or electron-beam (e-beam) patterning, possibly in conjunction with a suitable etching technique, e.g., a dry etch, such as e.g., RF reactive ion etch (RIE) or inductively coupled plasma (ICP) RIE. In some embodiments, the etch performed to form the fins 601-1-601-9 may include an anisotropic etch, using etchants in a form of e.g., chemically active ionized gas (i.e., plasma) using e.g., bromine (Br) and chloride (CI) based chemistries. In some embodiments, during the etch to form the fins 601-1-601-9 the IC structure may be heated to elevated temperatures, e.g., to temperatures between about room temperature and 200 degrees Celsius, including all values and ranges therein, to promote that byproducts of the etch are made sufficiently volatile to be removed from the surface.

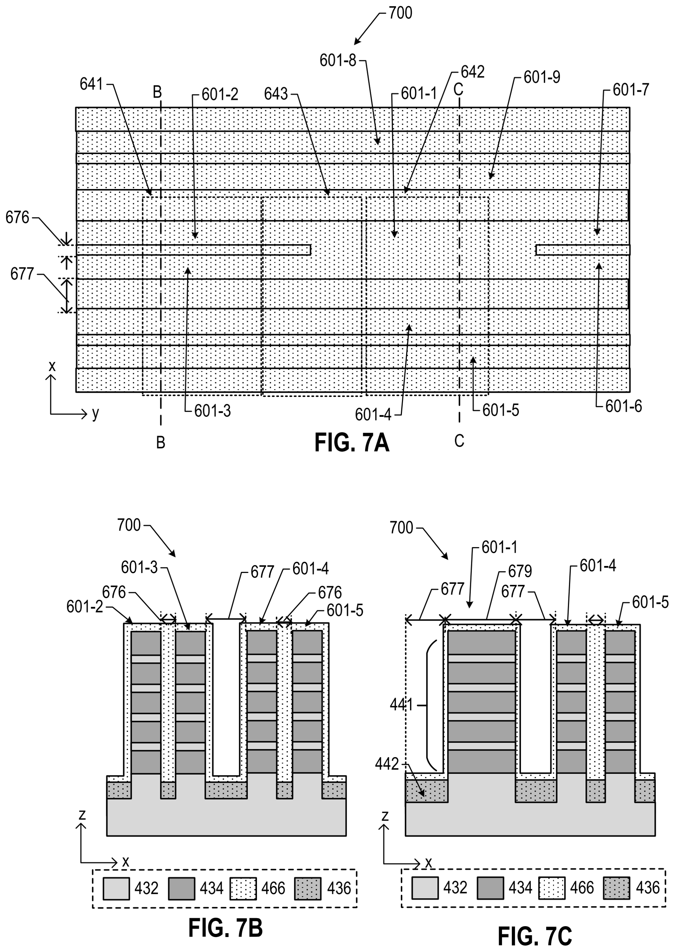

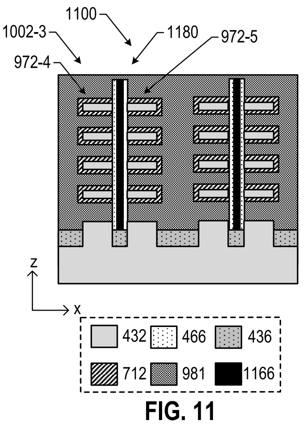

Referring again to FIG. 4, the method 400 continues with the process 406 of depositing a dielectric material over and between the fins. The IC structure 700 of FIGS. 7A-7C is an example resulting IC structure of the process 406. The IC structure 700 illustrates a dielectric material 466 over the fins 601-1-601-9, and on the bottom and sidewalls of openings/trenches between adjacent pairs of the fins 601-1-601-9. The dielectric material 466 may be deposited into the trench openings between adjacent fins using any suitable technique such as ALD, CVD, spin-coating, or dip-coating. The dielectric material 466 may include any suitable dielectric materials, e.g., any of the materials described above with references to low-k or high-k dielectric materials. Although a single dielectric material 466 is shown in FIGS. 7A-7C, in some examples, layers of two or more dielectric materials may be deposited (e.g., such as shown in FIG. 11, discussed below). In the example illustrated in FIGS. 7A-7B, an insulator material 436 may be deposited around the subfin regions prior to depositing the dielectric material 466. The insulator material 436 may include any insulator material typically used as a "shallow trench insulator" (STI) in fin-based or nanoribbon-based transistors, e.g., any suitable low-k dielectric material or other suitable insulator material. The insulator materials 436 and 466 may be the same or different.

As can be seen in FIGS. 7B-7C, portions of the dielectric material 466 between the more closely-spaced adjacent fins merged to form a dielectric wall coupled with and between those fins. For example, the dielectric material 466 on the sidewalls of an opening between the fin 601-2 and the fin 601-3 merged together to substantially fill the opening between the fins 601-2 and 601-3. Similarly, the dielectric material 466 on the sidewalls of an opening between the fins 601-4 and 601-5 merged to form a dielectric wall between the fins 601-4 and 601-5. In contrast, the opening between the fins 601-1 and 601-4 is wider, and the dielectric material on sidewalls of the opening between the fins 601-1 and 601-4 did not merge (e.g., the opening between the fins is lined with the dielectric material 466, but not filled with the dielectric material 466).

FIG. 4 continues with a process 408 of removing the dielectric material from between the more widely-spaced fins. The IC structure 800 of FIGS. 8A-8C is an example resulting IC structure of the process 408. As can be seen in FIGS. 8A-8C, the dielectric material 466 has been removed from widely-spaced adjacent fins. For example, the dielectric material 466 was removed from between the fin 601-3 and the fin 601-4 and from between the fin 601-1 and fins adjacent to the fin 601-1. The dielectric material 466 between the closely-spaced fins was not removed. For example, the merged portions of the dielectric material 466 between the fin 601-2 and the fin 601-3 has not been removed. The dielectric material 466 has also been removed from over the tops of the fins 601-1-601-9.

Referring again to FIG. 4, the method continues with the process 410 of removing the second semiconductor material to release nanoribbons of the semiconductor material. The IC structure 900 of FIGS. 9A-9C is an example resulting IC structure of the process 410. Removal of the second semiconductor material 434 may include any suitable etching technique. As can be seen in FIGS. 9A-9C, removal of the second semiconductor material 434 results in nanoribbons (e.g., stacks of nanoribbons stacked over one another) of the semiconductor material 432. Specifically, the IC structure 900 includes nanoribbons 972-2 and 972-3 adjacent to and coupled with the dielectric wall 980, and nanoribbons 972-1 that are not adjacent to or coupled with a dielectric wall. The example illustrated in FIGS. 9A-9C also includes the nanoribbons 972-4 and 972-5 on either side of a dielectric wall 982, nanoribbons 972-6 and 972-7 on either side of a dielectric wall 981, and nanoribbons 972-8 and 972-9 on either side of a dielectric wall 983. In the example illustrated in FIGS. 9A-9C, there are four nanoribbons in each of the stacks, although the stacks could include fewer than or more than four nanoribbons. Thus, the nanoribbons 972-1-972-9 are "released" in that openings 904 are formed around channel portions of the nanoribbons 972-1-972-9 of the semiconductor material 432.

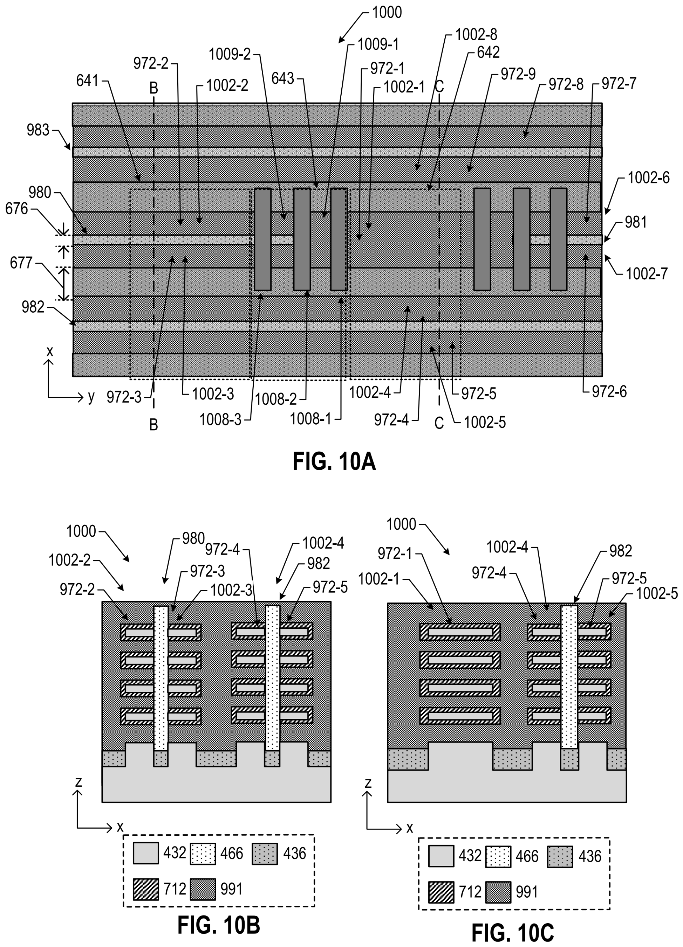

The method may continue with a process 412 of forming a first transistor (e.g., nanocomb transistor) in nanoribbons adjacent to and coupled with a dielectric wall, and a second transistor (e.g., a gate-all-around transistor) in nanoribbons that are not coupled with a dielectric wall. Forming transistors may involve processes such as forming S/D regions (e.g., prior to releasing the nanoribbons), providing a gate insulator material around gate regions of the nanoribbons, and providing a gate electrode material at least partially around the nanoribbons. The IC structure 1000 of FIGS. 10A-10C is an example IC structure resulting from the process of forming a first and second transistor in the nanoribbons. The view shown in FIG. 10A depicts a top-down plan view of the IC structure 1000 that shows the location of various elements that may not be visible from an actual top-down view, e.g., the dielectric walls and distances between adjacent nanoribbons.

As can be seen in FIGS. 10B-10C, the IC structure 1000 includes a gate insulator material 712 at least partially around the nanoribbons 972-1, 972-2, and 972-3. In the example illustrated in FIGS. 10A-10C, the gate insulator material is around three sides of the nanoribbons 972-2, around three sides of the nanoribbons 972-3, and around four sides of the nanoribbons 972-1. In other examples, the gate insulator material 712 may be present between the nanoribbons 972-2 and the dielectric wall 980 and/or between the nanoribbons 972-3 and the dielectric wall 980. The gate insulator material 712 may be an example of the gate insulator material 112. In some embodiments, the gate insulator material 712 may be absent in the IC structure 1000. The IC structure 1000 also includes a conductive material 991 at least partially around the nanoribbons 972-1, 972-2, and 972-3. In the example illustrated in FIGS. 10A-10C, the conductive material 991 is around three sides of the nanoribbons 972-2, around three sides of the nanoribbons 972-3, and around four sides of the nanoribbons 972-1. In other examples, the conductive material 991 may be present between the nanoribbons 972-2 and the dielectric wall 980 and/or between the nanoribbons 972-3 and the dielectric wall 980. The conductive material 991 may be an example of the gate electrode material 108 discussed above. Thus, in the example illustrated in FIGS. 10A-10C, the IC structure 1000 includes a nanocomb transistor 1002-2 having a channel region in the nanoribbons 972-2 on one side of the dielectric wall 980, a nanocomb transistor 1002-3 having a channel region in the nanoribbons 972-3 on the opposite side of the dielectric wall 980, and a gate-all-around transistor 1002-1 having channel regions in the nanoribbons 972-1. In the example illustrated in FIG. 10A, the region 643 between the nanocomb-transistor region 641 (e.g., with the transistor 1002-1) and the region 642 with the gate-all-around may represent a transition and/or dummy region that lacks active transistors.

As mentioned above, in some examples, a dielectric spine may include more than a single dielectric material. FIG. 11 illustrates a cross-sectional view of an IC structure 1100 that includes a dielectric wall 1180 that includes two dielectric materials. As can be seen in FIG. 11, the dielectric wall 1180 includes a first dielectric material 1166 between portions of a second dielectric material 466. In one example, the first dielectric material 1166 and dielectric material 466 may have different material compositions, and may be provided between the nanoribbons 972-4 and the nanoribbons 972-5 by depositing a thin layer of the dielectric material 466 on sidewalls of an openings between the fins, and then filling the remaining opening with the first dielectric material 1166 over the dielectric material 466.

Thus, the method 400 is an example method of fabricating an IC structure using techniques for forming a gate-all-around transistor in a nanocomb-transistor region. Performing the method 400 may result in features in the final IC structures that are characteristic of the use of the method 400. For example, one such feature is illustrated in the IC structure 1000 shown in FIGS. 10A-10C, which includes a dielectric wall 980 over and substantially orthogonal to a substrate, where the dielectric wall has a first side and a second side opposite the first side, a first transistor (e.g., a nanocomb transistor) 1002-2 including a first channel region in a first nanoribbon 972-2 of a semiconductor material, where the first nanoribbon 972-2 is adjacent to and coupled with the first side of the dielectric wall 980. The IC structure 1000 includes a second transistor (e.g., a nanocomb transistor) 1002-3 including a second channel region in a second nanoribbon 972-3 of the semiconductor material, where the second nanoribbon 972-3 is adjacent to and coupled with the second side of the dielectric wall 980. The IC structure 1000 includes a third transistor (e.g., a gate-all-around transistor) including a third channel region in a third nanoribbon 972-1 of the semiconductor material, where the third nanoribbon 972-1 extends along a same line as the dielectric wall 980, and two or more isolation regions (e.g., isolation regions 1008-1, 1008-2, and 1008-3) including an insulator material between the first transistor 1002-2 and the third transistor 1002-1. In the example illustrated in FIGS. 10A-10C, a semiconductor region (e.g., a dummy nanoribbon portion) including the semiconductor material is between the two or more isolation regions (e.g., there may be at least two isolation regions and a region of semiconductor material between the gate-all-around transistor and the nanocomb transistors).

In the example illustrated in FIGS. 10A-10C, the gate-all-around transistor 1002-1 may be surrounded on three or four sides by nanocomb transistors. For example, the IC structure 1000 includes a first transistor 1002-1 (e.g., a gate-all-around transistor) with a first channel region in a first nanoribbon 972-1 of a semiconductor material, second transistors (e.g., nanocomb transistors, such as the transistors 1002-2, 1002-3, 1002-4, 1002-5, 1002-6, 1002-7, and 1002-8) coplanar with the first transistor, wherein different ones of the second transistors are adjacent to the first transistor 1002-1 on at least three sides of the first transistor 1002-1. For example, the transistor 1002-2 is adjacent to the transistor 1002-1 on one side, the transistor 1002-6 is adjacent to the transistor 1002-1 on another side of the transistor 1002-1 opposite the transistor 1002-2. Similarly, the transistor 1002-4 is adjacent to the transistor 1002-1 on one side of the transistor 1002-1, and the transistor 1002-8 is adjacent to the transistor 1002-1 on another side opposite the transistor 1002-4. Each of the second transistors has a second channel region in a nanoribbon adjacent to and coupled with a first side of a dielectric wall, where an additional nanoribbon is coupled with a second side of the dielectric wall opposite the first side. For example the transistor 1002-2 has a channel region in the nanoribbon 972-2, which is coupled to the dielectric wall 980. In one such example, the nanoribbon 972-2 is separated from the nanoribbon on the other side of the dielectric wall 306 by a first distance 676 (e.g., the width of the dielectric wall), and the nanoribbon 972-1 is separated from adjacent nanoribbons (e.g., from the nanoribbon 972-4) by a second distance 677 that is greater than the first distance 676.

Another such feature that may be indicative of the use of the method 400 can be seen in FIGS. 10A-10C, where the first nanoribbon (e.g., one of the nanoribbons 972-1) and the fourth nanoribbon (e.g., one of the nanoribbons 972-4) are separated by a first distance 677, the second nanoribbon (e.g., one of the nanoribbons 972-2) and the third nanoribbon (e.g., one of the nanoribbons 972-3) are separated by a second distance 676, and where the first distance 677 is about 1.1 to 10 times greater than the second distance 676.

Another such feature that may be indicative of the use of the method 400 can be seen in FIGS. 10A-10C, where the IC structure includes a transition or dummy region 643 that includes a first insulator region 1008-1 between the first nanoribbon 972-1 and the second nanoribbon 972-2, a second insulator region 1008-2 between the first insulator region 1008-1 and the second nanoribbon 972-2, and a portion 1009-1 of the semiconductor material (e.g., a dummy portion of the semiconductor material 432) between the first insulator region 1008-1 and the second insulator region 1008-2. The region 643 further includes a third insulator region 1008-3 between the second insulator region 1008-2 and the second nanoribbon 972-2, and a second portion 1009-2 of the semiconductor material 432 between the second insulator region 1008-2 and the third insulator region 1008-3.

IC structures fabricated using techniques for forming a gate-all-around transistor in a nanocomb-transistor region as described herein (e.g., as described with reference to FIGS. 1, 2A-2B, 3A-3E, 4, 5A-5C, 6A-6C, 7A-7C, 8A-8C, 9A-9C, 10A-10C, and 11) may be used to implement any suitable components. For example, in various embodiments, transistors described herein may be part of one or more of: a central processing unit, a memory device (e.g., a high-bandwidth memory device), a memory cell, a logic circuit, input/output circuitry, a field programmable gate array (FPGA) component such as an FPGA transceiver or an FPGA logic, a power delivery circuitry, an amplifier (e.g., a III-V amplifier), Peripheral Component Interconnect Express (PCIE) circuitry, Double Data Rate (DDR) transfer circuitry, a computing device (e.g., a wearable or a handheld computing device), etc.

The IC structures disclosed herein, e.g., the IC structures 200A, 200B, 300, 1000, and 1100 may be included in any suitable electronic component. FIGS. 12-16 illustrate various examples of apparatuses that may include the IC structures 200A, 200B, 300, 1000, and 1100 disclosed herein.

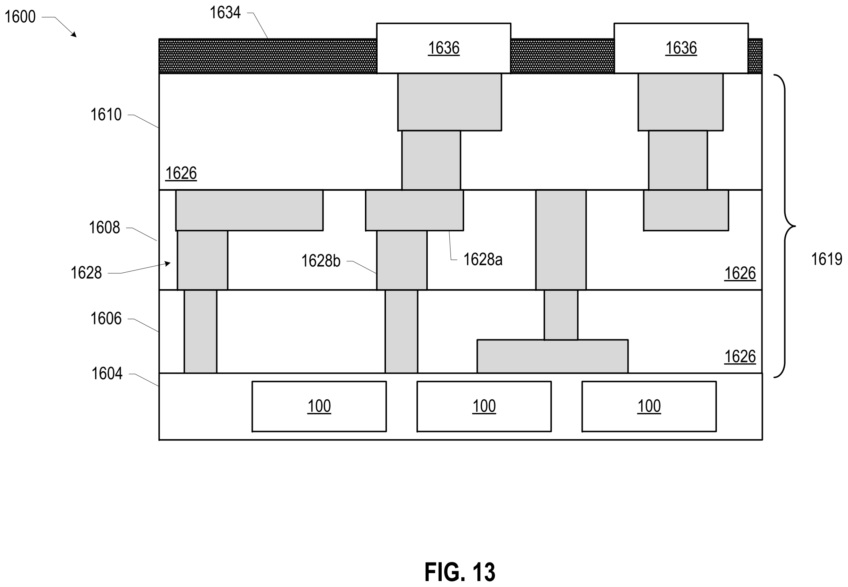

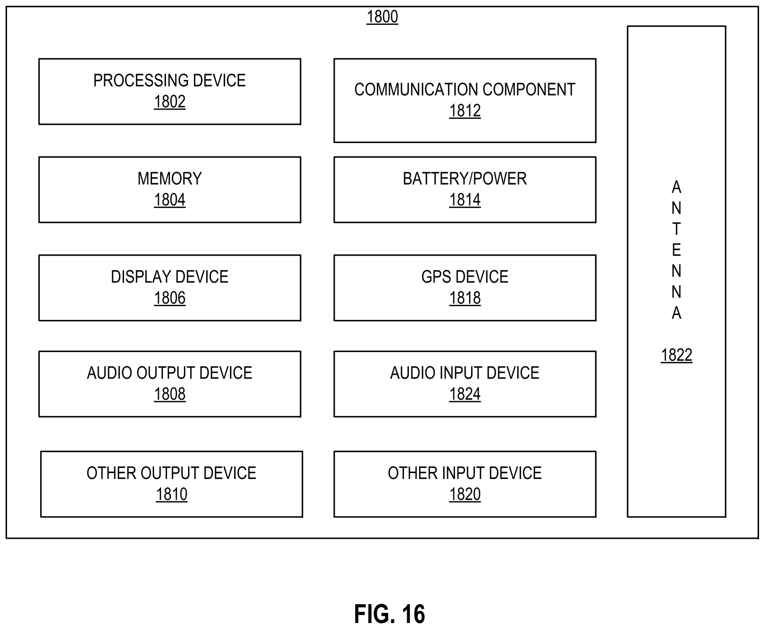

FIG. 12 is a top view of a wafer 1500 and dies 1502 that may include one or more IC structures 200A, 200B, 300, 1000, and 1100 in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more IC structures 200A, 200B, 300, 1000, and 1100 (e.g., as discussed below with reference to FIG. 13), one or more transistors (e.g., some of the transistors of the device region 1604 of FIG. 13, discussed below, e.g., nanoribbon-based transistors of the IC structures 200A, 200B, 300, 1000, and 1100) and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 16) or other logic that is configured to store information in the memory devices or execute instructions stored in the memory array.

FIG. 13 is a side, cross-sectional view of an IC device 1600 that may include one or more IC structures in accordance with any of the embodiments disclosed herein (e.g., in accordance with IC structures 200A, 200B, 300, 1000, and 1100). One or more of the IC devices 1600 may be included in one or more dies 1502 (FIG. 12). The IC device 1600 may include a device region 1604 including one or more IC structures (e.g., one or more of IC structures 200A, 200B, 300, 1000, and 1100) disclosed herein, or any variations of the IC structures. The device region 1604 may further include electrical contacts to the gates of the transistors included in the device region 1604 and to the S/D materials of the transistors included in the device region 1604 (e.g., to the S/D regions 114 of the IC structure 100).

Electrical signals, such as power and/or input/output (I/O) signals, may be routed to and/or from the devices (e.g., the transistors) of the device region 1604 through one or more interconnect layers disposed on the device region 1604 (illustrated in FIG. 13 as interconnect layers 1606-1610). For example, electrically conductive features of the device region 1604 (e.g., the gate electrode material 108 of the IC structure 100) may be electrically coupled with the interconnect structures 1628 of the interconnect layers 1606-1610. The one or more interconnect layers 1606-1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 13). Although a particular number of interconnect layers 1606-1610 is depicted in FIG. 13, embodiments of the present disclosure include IC structures having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the support 102 upon which the device region 1604 is formed. For example, the lines 1628a may route electrical signals in a direction in and out of the page from the perspective of FIG. 13. The vias 1628b may be arranged to route electrical signals in a direction of a plane that is substantially perpendicular to the surface of the support 102 upon which the device region 1604 is formed. In some embodiments, the vias 1628b may electrically couple lines 1628a of different interconnect layers 1606-1610 together.

The interconnect layers 1606-1610 may include a dielectric material 1626 disposed between the interconnect structures 1628, as shown in FIG. 13. In some embodiments, the dielectric material 1626 disposed between the interconnect structures 1628 in different ones of the interconnect layers 1606-1610 may have different compositions; in other embodiments, the composition of the dielectric material 1626 between different interconnect layers 1606-1610 may be the same.

A first interconnect layer 1606 may be formed above the device region 1604. In some embodiments, the first interconnect layer 1606 may include lines 1628a and/or vias 1628b, as shown. The lines 1628a of the first interconnect layer 1606 may be coupled with contacts (e.g., contacts to the S/D regions 114 of the IC structure 100) of the device region 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device region 1604) may be thicker.

The IC device 1600 may include a solder resist material 1634 (e.g., polyimide or similar material) and one or more conductive contacts 1636 formed on the interconnect layers 1606-1610. In FIG. 13, the conductive contacts 1636 are illustrated as taking the form of bond pads. The conductive contacts 1636 may be electrically coupled with the interconnect structures 1628 and configured to route the electrical signals of the transistor(s) of the device region 1604 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606-1610; for example, the conductive contacts 1636 may include other analogous features (e.g., posts) that route the electrical signals to external components.

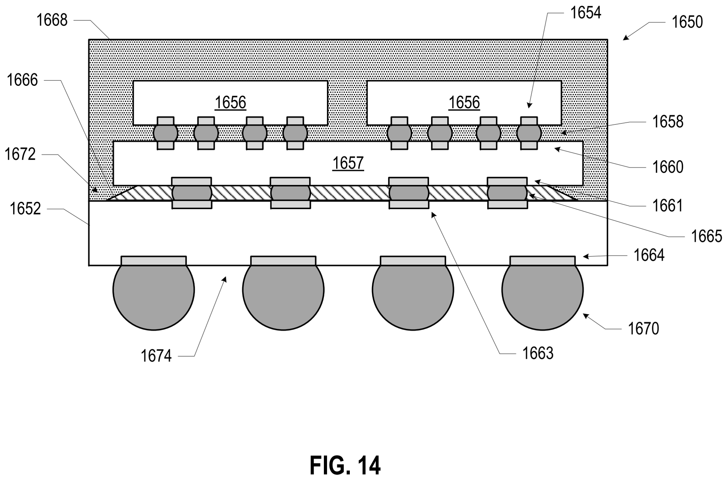

FIG. **14** is a side, cross-sectional view of an example IC package 1650 that may include one or more IC structures 200A, 200B, 300, 1000, and 1100 in accordance with any of the embodiments disclosed herein. In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674. These conductive pathways may take the form of any of the interconnect structures 1628 discussed above with reference to FIG. 13.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 14 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 14 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

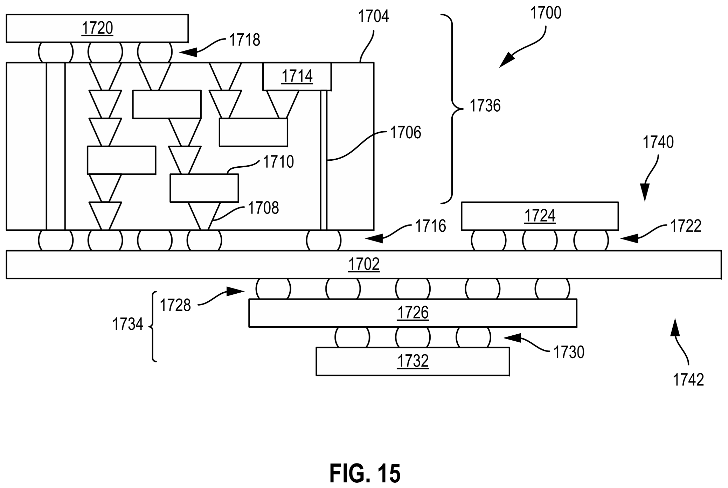

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 14 are solder balls (e.g., for a ball grid array arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 15.

The dies 1656 may take the form of any of the embodiments of the die 1502 discussed herein (e.g., may include any of the embodiments of the IC device 1600). In embodiments in which the IC package 1650 includes multiple dies 1656, the IC package 1650 may be referred to as a multichip package (MCP). The dies 1656 may include circuitry to perform any desired functionality. For example, or more of the dies 1656 may be logic dies (e.g., silicon-based dies), and one or more of the dies 1656 may be memory dies (e.g., high-bandwidth memory).

Although the IC package 1650 illustrated in FIG. 14 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 14, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 15 is a side, cross-sectional view of an IC device assembly 1700 that may include one or more IC packages or other electronic components (e.g., a die) including one or more IC structures 200A, 200B, 300, 1000, and 1100 in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 14 (e.g., may include one or more IC structures 200A, 200B, 300, 1000, and 1100).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 15 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 15), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 15, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 12), an IC device (e.g., the IC device 1600 of FIG. 13), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 15, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 15 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 16 is a block diagram of an example electrical device 1800 that may include one or more IC structures 200A, 200B, 300, 1000, and 1100 in accordance with any of the embodiments disclosed herein. For example, any suitable ones of the components of the electrical device 1800 may include one or more of the IC device assemblies 1700, IC packages 1650, IC devices 1600, or dies 1502 disclosed herein. A number of components are illustrated in FIG. 16 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 16, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic RAM (eDRAM) or spin transfer torque magnetic RAM (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides an IC structure, including a dielectric wall (e.g., a spine) over and substantially orthogonal to a substrate, where the dielectric wall has a first side and a second side opposite the first side; a first transistor (e.g., a nanocomb transistor) including a first channel region in a first nanoribbon of a semiconductor material, where the first nanoribbon is adjacent to and coupled with the first side of the dielectric wall; a second transistor (e.g., a nanocomb transistor) including a second channel region in a second nanoribbon of the semiconductor material, where the second nanoribbon is adjacent to and coupled with the second side of the dielectric wall; a third transistor (e.g., a gate-all-around transistor) including a third channel region in a third nanoribbon of the semiconductor material, where the third nanoribbon extends along a same line as the dielectric wall; and two or more isolation regions including an insulator material between the first transistor and the third transistor; and a semiconductor region (e.g., a dummy nanoribbon portion) including the semiconductor material between the two or more isolation regions.

Example 2 provides the IC structure of example 1, where: the third nanoribbon (e.g., a wider nanoribbon forming the basis of the gate-all-around transistor) is between and adjacent to additional nanoribbons that are coplanar and parallel to the third nanoribbon, the third nanoribbon is separated from one of the additional nanoribbons by a first distance (e.g., the distance between nanoribbons without a spine between them), the first nanoribbon is separated from the second nanoribbon by a second distance (e.g., the distance between nanoribbons with a spine between them), and the first distance is about 1.1 to 3 times greater than the second distance.

Example 3 provides the IC structure of example 2, where the dielectric wall is a first dielectric wall, the one of the additional nanoribbons is a fourth nanoribbon, and where the IC structure further includes a second dielectric wall parallel to the first dielectric wall, where the fourth nanoribbon is between the third nanoribbon and the second dielectric wall and coupled with the second dielectric wall; and a fourth transistor (e.g., a nanocomb transistor) including a fourth channel region in the fourth nanoribbon.

Example 4 provides the IC structure of example 3, where another of the additional nanoribbons is a fifth nanoribbon, and where the IC structure further includes a third dielectric wall parallel to the first dielectric wall, where the fifth nanoribbon is between the third nanoribbon and the third dielectric wall and coupled with the third dielectric wall; and a fifth transistor (e.g., a nanocomb transistor) including a fifth channel region in the fifth nanoribbon.

Example 5 provides the IC structure of example 4, further including a fourth dielectric wall extending along the same line as the third nanoribbon and the first dielectric wall, where the first dielectric wall is adjacent to one end of the third nanoribbon and the fourth dielectric wall is adjacent to another end of the third nanoribbon; and a sixth transistor (e.g., a nanocomb transistor) including a sixth channel region in a sixth nanoribbon, where the sixth nanoribbon is adjacent to and coupled with the fourth dielectric wall.

Example 6 provides the IC structure of any one of examples 1-5, where: in a cross-section in a plane substantially parallel with the substrate, the dielectric wall includes a first dielectric material between portions of a second dielectric material.

Example 7 provides the IC structure of any one of examples 1-6, where: the first nanoribbon has a first width, the second nanoribbon has a second width, the third nanoribbon has a third width, and the third width is greater than the first width and greater than the second width (e.g., the nanoribbon not adjacent to the dielectric wall/spine is wider than a nanoribbon coupled with the dielectric wall).

Example 8 provides the IC structure of example 7, where: the third width is greater than the first width plus the second width.

Example 9 provides the IC structure of example 7, where: the third width is greater than the first width plus a width of the dielectric wall.

Example 10 provides the IC structure of any one of examples 1-9, where: the first channel region is at a first distance from another channel region of an adjacent transistor in the first nanoribbon, the first nanoribbon is at a second distance from the third nanoribbon (e.g., where the second distance may represent the length of a transition region), and the second distance is in a range of about one to two times the first distance.

Example 11 provides an IC structure, including a first transistor (e.g., a gate-all-around transistor) with a first channel region in a first nanoribbon of a semiconductor material; second transistors (e.g., nanocomb transistors) coplanar with the first transistor, where: different ones of the second transistors are adjacent to the first transistor on at least three sides of the first transistor (e.g., nanocomb transistors may be adjacent to at least three sides of the gate-all-around transistor), each of the second transistors includes a second channel region in a second nanoribbon adjacent to and coupled with a first side of a dielectric wall, where an additional nanoribbon is coupled with a second side of the dielectric wall opposite the first side, the second nanoribbon is separated from the additional nanoribbon by a first distance (e.g., the width of the dielectric wall), and the first nanoribbon is separated from an adjacent nanoribbon by a second distance that is greater than the first distance.

Example 12 provides the IC structure of example 11, where: the second distance is about 1.1 to 1.3 times greater than the first distance.

Example 13 provides the IC structure of any one of examples 11-12, where: different ones of the second transistors are adjacent to the first transistor on four sides of the first transistor (e.g., the gate-all-around transistor may be surrounded by nanocomb transistors).

Example 14 provides the IC structure of any one of examples 11-13, where: the dielectric wall adjacent to one of the second transistors extends along a same line as the first nanoribbon, the dielectric wall and the first nanoribbon are separated by a first insulator region and a second insulator region (e.g., there may be a transition/dummy region with isolation regions), and a dummy nanoribbon of the semiconductor material is between the first insulator region and the second insulator region.

Example 15 provides the IC structure of any one of examples 11-13, where: the dielectric wall adjacent to one of the second transistors extends along a same line as the first nanoribbon, the dielectric wall and the first nanoribbon are separated by a first insulator region, a second insulator region, and a third insulator region (e.g., there may be a transition/dummy region with isolation regions), a first dummy nanoribbon of the semiconductor material is between the first insulator region and the second insulator region, and a second dummy nanoribbon of the semiconductor material is between the first insulator region and the second insulator region.

Example 16 provides the IC structure of any one of examples 11-15, where: in a cross-section in a plane substantially parallel with the device region, the first dielectric wall includes a first dielectric material between portions of a second dielectric material.

Example 17 provides the IC structure of any one of examples 11-16, where: the first nanoribbon has a first width, one of the second nanoribbons has a second width, and the first width is greater than the second width (e.g., the nanoribbon without the dielectric wall/spine is wider than a nanoribbon on the dielectric wall).

Example 18 provides the IC structure of example 17, where: the first width is greater than the second width plus a width of the dielectric wall.

Example 19 provides an IC structure according to any one of examples 1-18, where the IC structure includes or is a part of a central processing unit.

Example 20 provides an IC structure according to any one of examples 1-19, where the IC structure includes or is a part of a memory device.

Example 21 provides an IC structure according to any one of examples 1-20, where the IC structure includes or is a part of a logic circuit.

Example 22 provides an IC structure according to any one of examples 1-21, where the IC structure includes or is a part of input/output circuitry.

Example 23 provides an IC structure according to any one of examples 1-22, where the IC structure includes or is a part of a field programmable gate array transceiver.

Example 24 provides an IC structure according to any one of examples 1-23, where the IC structure includes or is a part of a field programmable gate array logic.

Example 25 provides an IC structure according to any one of examples 1-24, where the IC structure includes or is a part of a power delivery circuitry.

Example 26 provides an IC package that includes an IC die including an IC structure according to any one of examples 1-25; and a further IC component, coupled to the IC die.

Example 27 provides an IC package according to example 26 where the further IC component includes a package substrate.

Example 28 provides an IC package according to example 26, where the further IC component includes an interposer.

Example 29 provides an IC package according to example 26, where the further IC component includes a further IC die.

Example 30 provides a computing device that includes a carrier substrate and an IC structure coupled to the carrier substrate, where the IC structure is an IC structure according to any one of examples 1-25, or the IC structure is included in the IC package according to any one of examples 26-29.

Example 31 provides a computing device according to example 30, where the computing device is a wearable or handheld computing device.

Example 32 provides a computing device according to examples 30 or 31, where the computing device further includes one or more communication chips.

Example 33 provides a computing device according to any one of examples 30-32, where the computing device further includes an antenna.

Example 34 provides a computing device according to any one of examples 30-33, where the carrier substrate is a motherboard.

Example 35 provides a method of making an integrated circuit structure, the method including providing a stack of alternate layers of a first semiconductor material and a second semiconductor material; patterning the stack into fins, where the fins include: a first fin and a second fin parallel and adjacent to the first fin, where the first fin and the second fin are separated by a first distance, a third fin extending along a same line as the first fin (e.g., and the second fin), and a fourth fin parallel and adjacent to the third fin, where the third fin and the fourth fin are separated by a second distance that is greater than the first distance (e.g., 1.1 to 1.2 times greater); providing a dielectric material over and between the fins, where portions of the dielectric material between the first fin and the second fin merge to form a dielectric wall; removing the second semiconductor material to release nanoribbons of the first semiconductor material, including a first nanoribbon from the first fin, a second nanoribbon from the second fin, and a third nanoribbon from the third fin; forming a first transistor (e.g., a nanocomb transistor) with a first channel region in the first nanoribbon; and forming a second transistor with a second channel region in the third nanoribbon (e.g., a gate-all-around transistor).

Example 36 provides the method of example 35, where: the first fin has a first width, the second fin has a second width, the third fin has a third width, and the third width is greater than the first width and greater than the second width.

Example 37 provides a method according to any one of examples 35-43, where the IC structure is an IC structure according to any one of the preceding examples.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) structure, comprising:
a dielectric wall over and substantially orthogonal to a substrate, wherein the dielectric wall has a first side and a second side opposite the first side;
a first transistor comprising a first channel region in a first nanoribbon of a semiconductor material, wherein the first nanoribbon is adjacent to and coupled with the first side of the dielectric wall;
a second transistor comprising a second channel region in a second nanoribbon of the semiconductor material, wherein the second nanoribbon is adjacent to and coupled with the second side of the dielectric wall;
a third transistor comprising a third channel region in a third nanoribbon of the semiconductor material, wherein the third nanoribbon extends along a same line as the dielectric wall;
two or more isolation regions comprising an insulator material between the first transistor and the third transistor; and
a semiconductor region comprising the semiconductor material between the two or more isolation regions.

2. The IC structure of claim 1, wherein:
the third nanoribbon is between and adjacent to additional nanoribbons that are coplanar and parallel to the third nanoribbon,
the third nanoribbon is separated from one of the additional nanoribbons by a first distance,
the first nanoribbon is separated from the second nanoribbon by a second distance, and
the first distance is about 1.1 to 3 times greater than the second distance.

3. The IC structure of claim 2,
wherein the dielectric wall is a first dielectric wall, the one of the additional nanoribbons is a fourth nanoribbon, and wherein the IC structure further comprises:
a second dielectric wall parallel to the first dielectric wall, wherein the fourth nanoribbon is between the third nanoribbon and the second dielectric wall and coupled with the second dielectric wall; and
a fourth transistor comprising a fourth channel region in the fourth nanoribbon.

4. The IC structure of claim 3,
wherein another of the additional nanoribbons is a fifth nanoribbon, and wherein the IC structure further comprises:
a third dielectric wall parallel to the first dielectric wall, wherein the fifth nanoribbon is between the third nanoribbon and the third dielectric wall and coupled with the third dielectric wall; and
a fifth transistor comprising a fifth channel region in the fifth nanoribbon.

5. The IC structure of claim 4, further comprising:
a fourth dielectric wall extending along the same line as the third nanoribbon and the first dielectric wall, wherein the first dielectric wall is adjacent to one end of the third nanoribbon and the fourth dielectric wall is adjacent to another end of the third nanoribbon; and
a sixth transistor comprising a sixth channel region in a sixth nanoribbon, wherein the sixth nanoribbon is adjacent to and coupled with the fourth dielectric wall.

6. The IC structure of any one of claims 1-5, wherein:
in a cross-section in a plane substantially parallel with the substrate, the dielectric wall comprises a first dielectric material between portions of a second dielectric material.

7. The IC structure of any one of claims 1-6, wherein:
the first nanoribbon has a first width,
the second nanoribbon has a second width,
the third nanoribbon has a third width, and
the third width is greater than the first width and greater than the second width.

8. The IC structure of claim 7, wherein:
the third width is greater than the first width plus the second width.

9. The IC structure of claim 7, wherein:
the third width is greater than the first width plus a width of the dielectric wall.

10. The IC structure of claim 8, wherein:
the third width is smaller than a combined width of the first nanoribbon, the second nanoribbon, and the width of the dielectric wall.

11. The IC structure of claim 7, wherein:
the third width is about the same as a combined width of the first nanoribbon, the second nanoribbon, and the dielectric wall.

12. The IC structure of any one of claims 1-11, wherein:
the first channel region is at a first distance from another channel region of an adjacent transistor in the first nanoribbon,
the first nanoribbon is at a second distance from the third nanoribbon, and
the second distance is in a range of about one to two times the first distance.

13. The IC structure of any one of claims 1-12, wherein:
the two or more isolation regions comprise three isolation regions.

14. The IC structure of any one of claims 1-13, further comprising:
metal gate lines over the first nanoribbon and substantially orthogonal to the first nanoribbon, wherein;
a first distance between adjacent metal gate lines is about the same as a second distance between adjacent isolation regions of the two or more isolation regions.

15. The IC structure of any one of claims 1-14, further comprising:
an inactive region comprising the two or more isolation regions, wherein the inactive region lacks conductive connection to metal lines of a metallization stack over the first nanoribbon.
